(19) Europäisches Patentamt / European Patent Office / Office européen des brevets

(11) **EP 3 636 432 B1**

(12) **EUROPEAN PATENT SPECIFICATION**

(45) Date of publication and mention of the grant of the patent:
**13.07.2022 Bulletin 2022/28**

(21) Application number: **19210953.6**

(22) Date of filing: **02.11.2012**

(51) International Patent Classification (IPC):
***B32B 27/00*** (2006.01) ***B32B 9/00*** (2006.01)
***C08K 5/103*** (2006.01) ***C08L 101/00*** (2006.01)
***H01L 51/50*** (2006.01) ***H05B 33/02*** (2006.01)
***B32B 27/28*** (2006.01) ***B32B 27/32*** (2006.01)
***C23C 14/48*** (2006.01) ***G02F 1/1333*** (2006.01)
***H01L 51/52*** (2006.01)

(52) Cooperative Patent Classification (CPC):
**C08J 7/048; B32B 27/08; B32B 27/26; B32B 27/286; B32B 27/365; C08J 7/0427; C08J 7/043; C08J 7/044; C08J 7/06; H01L 51/5256;** B32B 2255/10; B32B 2255/26; B32B 2307/702; B32B 2307/7242; B32B 2307/748;

(Cont.)

(54) **GAS BARRIER FILM, METHOD FOR PRODUCING SAME, GAS BARRIER FILM LAMINATE, MEMBER FOR ELECTRONIC DEVICES, AND ELECTRONIC DEVICE**

GASSPERRFOLIE, HERSTELLUNGSVERFAHREN DAFÜR, GASSPERRFOLIENLAMINAT, ELEMENT FÜR ELEKTRONISCHE VORRICHTUNGEN UND ELEKTRONISCHE VORRICHTUNG

FILM BARRIÈRE CONTRE LES GAZ, SON PROCÉDÉ DE FABRICATION, STRATIFIÉ DE FILM DE BARRIÈRE CONTRE LES GAZ, ÉLÉMENT POUR DES DISPOSITIFS ÉLECTRONIQUES ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.11.2011 JP 2011241941**

(43) Date of publication of application:
**15.04.2020 Bulletin 2020/16**

(62) Document number(s) of the earlier application(s) in accordance with Art. 76 EPC:
**12846522.6 / 2 774 755**

(73) Proprietor: **LINTEC Corporation**
**Tokyo 173-0001 (JP)**

(72) Inventors:
- **Iwaya, Wataru**
  **Tokyo, 173-0001 (JP)**
- **Fujimoto, Hironobu**
  **Tokyo, 173-0001 (JP)**
- **Taya, Naoki**
  **Tokyo, 173-0001 (JP)**
- **Ito, Masaharu**
  **Tokyo, 173-0001 (JP)**
- **Kondo, Takeshi**
  **Tokyo, 173-0001 (JP)**

(74) Representative: **Gerauer, Marc Philippé**
**Kraus & Weisert**
**Patentanwälte PartGmbB**
**Thomas-Wimmer-Ring 15**
**80539 München (DE)**

(56) References cited:
**EP-A2- 2 033 988** **WO-A1-2010/107018**
**JP-A- 2000 227 603** **JP-A- 2005 262 529**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
B32B 2457/202; C08J 2345/00; C08J 2381/06; C08J 2483/16; C08K 5/103; C08K 2201/008; G02F 1/133311; G02F 1/133331; G02F 2201/501; G02F 2201/503

## Description

TECHNICAL FIELD

The invention relates to a gas barrier film that may preferably be used as an electronic device member for a liquid crystal display, an electroluminescence (EL) display, and the like, a method for producing the same, a gas barrier film laminate in which two or more gas barrier films are stacked, an electronic device member that includes the gas barrier film or the gas barrier film laminate, and an electronic device that includes the electronic device member.

BACKGROUND ART

In recent years, use of a transparent plastic film instead of a glass sheet (substrate) has been proposed for displays (e.g., liquid crystal display and electroluminescence (EL) display) in order to implement a reduction in thickness, a reduction in weight, an increase in flexibility, and the like.
However, since a plastic film generally allows water vapor, oxygen, and the like to easily pass through as compared with a glass sheet, the elements of a display may easily deteriorate when a transparent plastic film is used as a substrate of a display.
In order to solve this problem, it has been proposed to use a film that has a capability to suppress transmission (penetration) of water vapor and oxygen (hereinafter referred to as "gas barrier capability", and a film that has a gas barrier capability is hereinafter referred to as "gas barrier film") as the substrate of a display.
For example, Patent Document 1 discloses a flexible display substrate in which a transparent gas barrier layer formed of a metal oxide is stacked on the surface of a transparent plastic film using an evaporation (deposition) method, an ion plating method, a sputtering method, or the like.
Patent Document 2 discloses a gas barrier film in which a gas barrier layer formed by subjecting a polysilazane film to plasma treatment is provided on at least one side of a substrate (base).
Document EP2033988 (A) discloses a gas barrier film comprising a cured resin layer and a gas barrier layer.
In recent years, a display and the like having a higher performance have been desired, and a gas barrier film used for an electronic device member and the like has been required to exhibit various characteristics (e.g., excellent gas barrier capability, excellent heat resistance, excellent solvent resistance, excellent interlayer adhesion, low birefringence, and excellent optical isotropy).
However, a known gas barrier film does not meet the above requirement.
Therefore, a gas barrier film or a gas barrier film laminate that meets the above requirement has been desired.

RELATED-ART DOCUMENT

PATENT DOCUMENT

Patent Document 1: JP-A-2000-338901
Patent Document 2: JP-A-2007-237588

SUMMARY OF THE INVENTION

TECHNICAL PROBLEM

The invention was conceived in view of the above situation. An object of the invention is to provide a gas barrier film that exhibits excellent heat resistance, excellent solvent resistance, excellent interlayer adhesion, and an excellent gas barrier capability, has a low birefringence, and exhibits excellent optical isotropy, .a method for producing the same, a gas barrier film laminate in which two or more gas barrier films are stacked, an electronic device member that includes the gas barrier film or the gas barrier film laminate, and an electronic device that includes the electronic device member.

SOLUTION TO PROBLEM

The inventors of the invention conducted extensive studies relating to a gas barrier film that includes a gas barrier layer in order to achieve the above object, and found that a gas barrier film that includes a cured resin layer formed of a cured product of a curable resin composition having a specific composition, and a gas barrier layer provided on at least one side of the cured resin layer, exhibits excellent heat resistance, excellent solvent resistance, excellent

interlayer adhesion, and an excellent gas barrier capability, has a low birefringence, and exhibits excellent optical isotropy.

The inventors also found that the gas barrier film can be efficiently obtained by forming a curable resin layer of a curable resin composition on a process sheet using a solution casting method, curing the curable resin layer to form a cured resin layer, and forming a gas barrier layer on the cured resin layer.

The inventors further found that a gas barrier film laminate that exhibits an excellent gas barrier capability, excellent heat resistance, excellent solvent resistance, and excellent interlayer adhesion, has a low birefringence, and exhibits excellent optical isotropy, can be obtained by stacking two or more gas barrier films through a bonding layer. These findings have led to the completion of the invention.

ADVANTAGEOUS EFFECTS OF THE INVENTION

The gas barrier film according to the first aspect of the invention exhibits excellent heat resistance, excellent solvent resistance, excellent interlayer adhesion, and an excellent gas barrier capability, has a low birefringence, and exhibits excellent optical isotropy. The gas barrier film may suitably be used as an electronic device member for solar cells, touch panels, electronic paper, displays, and the like.

The method for producing a gas barrier film according to the second aspect of the invention can efficiently produce the gas barrier film according to the first aspect of the invention. The method for producing a gas barrier film according to the second aspect of the invention is particularly suitably be used when producing a gas barrier film having a very small thickness.

The gas barrier film laminate according to the third aspect of the invention exhibits an excellent gas barrier capability, excellent heat resistance, excellent solvent resistance, and excellent interlayer adhesion, has a low birefringence, and exhibits excellent optical isotropy.

Since the electronic device member according to the fourth aspect of the invention includes the gas barrier film or the gas barrier film laminate that exhibits excellent heat resistance, excellent solvent resistance, excellent interlayer adhesion, and an excellent gas barrier capability, has a low birefringence, and exhibits excellent optical isotropy, the electronic device member may suitably be used for an electronic device (e.g., touch panel, electronic paper, flexible display (e.g., organic/inorganic EL display), and solar cell).

BRIEF DESCRIPTION OF DRAWINGS

FIG. 1 is a cross-sectional view illustrating the layer configuration of a gas barrier film according to one embodiment of the invention.

FIG. 2 is a cross-sectional view illustrating the layer configuration of a gas barrier film laminate according to one embodiment of the invention.

FIG. 3 is a cross-sectional view illustrating the layer configuration of a gas barrier film laminate according to one embodiment of the invention.

FIG. 4 is a cross-sectional view illustrating the layer configuration of a gas barrier film laminate according to one embodiment of the invention.

FIG. 5 is a cross-sectional view illustrating the layer configuration of a gas barrier film laminate according to one embodiment of the invention.

FIG. 6 is a cross-sectional view illustrating a process that produces a gas barrier film laminate according to one embodiment of the invention.

DESCRIPTION OF EMBODIMENTS

A gas barrier film, a method for producing a gas barrier film, a gas barrier film laminate, an electronic device member, and an electronic device according to the embodiments of the invention are described in detail in below.

1) Gas barrier film

A gas barrier film according to one embodiment of the invention includes a cured resin layer according to the claims and a gas barrier layer, the gas barrier layer being provided on at least one side of the cured resin layer, the cured resin layer being a layer formed of a cured product of a curable resin composition that includes (A) a thermoplastic resin having a glass transition temperature (Tg) of 140°C or more, and (B) a curable monomer, the gas barrier film having a water vapor transmission rate of 1 g/$m^2$/day or less at a temperature of 40°C and a relative humidity of 90%.

(I) Cured resin layer

The cured resin layer included in the gas barrier film according to one embodiment of the invention is formed of a cured product of the curable resin composition that includes the thermoplastic resin (A) having a glass transition temperature (Tg) of 140°C or more, and the curable monomer (B). The cured resin layer may be a single layer, or may be a layer in which a plurality of layers are stacked.

Thermoplastic resin (A)

The thermoplastic resin (A) is a thermoplastic resin having a glass transition temperature (Tg) of 140°C or more, and preferably 150°C or more. A gas barrier film that exhibits excellent heat resistance can be obtained by utilizing a thermoplastic resin having a glass transition temperature (Tg) of 140°C or more.

The term "glass transition temperature (Tg)" used herein refers to the temperature corresponding to the maximum tanδ value (loss modulus/storage modulus) obtained by viscoelasticity measurement (frequency: 11 Hz, temperature increase rate 3°C/min, temperature range: 0 to 250°C, measured in tensile mode).

The weight average molecular weight (Mw) of the thermoplastic resin (A) is 100,000 to 3,000,000, preferably 200,000 to 2,000,000, and more preferably 500,000 to 2,000,000. The molecular weight distribution (Mw/Mn) of the thermoplastic resin (A) is preferably 1.0 to 5.0, and more preferably 2.0 to 4.5. Note that the terms "weight average molecular weight (Mw)" and "molecular weight distribution (Mw/Mn)" used herein refer to values determined by gel permeation chromatography (GPC) relative to a polystyrene standard (polystyrene-reduced values).

It is preferable that the thermoplastic resin (A) be an amorphous thermoplastic resin. A gas barrier film that exhibits excellent transparency can be easily obtained using the amorphous thermoplastic resin. Since the amorphous thermoplastic resin is easily dissolved in an organic solvent, a cured resin layer can be efficiently formed by utilizing a solution casting method (described later).

Note that the term "amorphous thermoplastic resin" used herein refers to a thermoplastic resin for which a melting point is not observed by differential scanning calorimetry.

The thermoplastic resin (A) is preferably a thermoplastic resin having a cyclic structure (e.g., aromatic ring structure or alicyclic structure), and more preferably a thermoplastic resin having an aromatic ring structure, from the viewpoint of heat resistance.

Specific examples of the thermoplastic resin (A) include a polysulfone-based resin, a polyallylate-based resin, a polycarbonate-based resin, an alicyclic hydrocarbon-based resin, and the like. Among these, a polysulfone-based resin is preferable from the viewpoint of heat resistance.

The term "polysulfone-based resin" used herein refers to a polymer that includes a sulfone group ($-SO_2-$) in the main chain. The polysulfone-based resin is not particularly limited. A known polysulfone-based resin may be used. Examples of the polysulfone-based resin include a polyethersulfone resin, a polysulfone resin, a polyphenylsulfone resin, and the like. The polysulfone-based resin may be a modified polysulfone-based resin. Specific examples of the polysulfone-based resin include a resin that includes a polymer compound including a repeating unit represented by a formula among the following formulas (a) to (h).

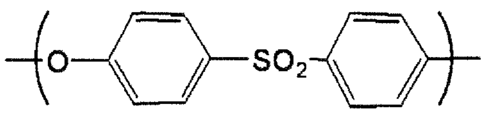

(a)

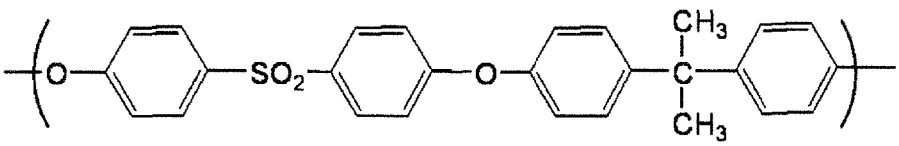

(b)

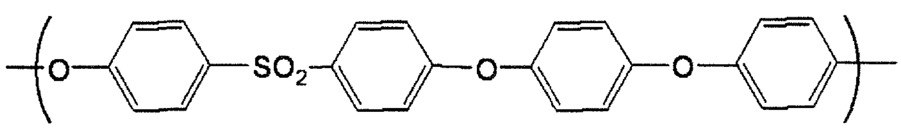

(c)

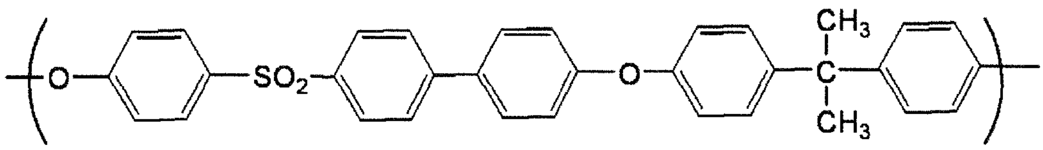
(d)

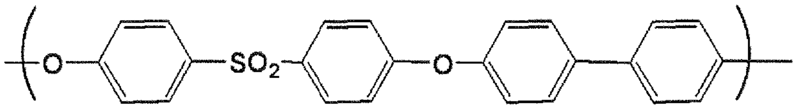
(e)

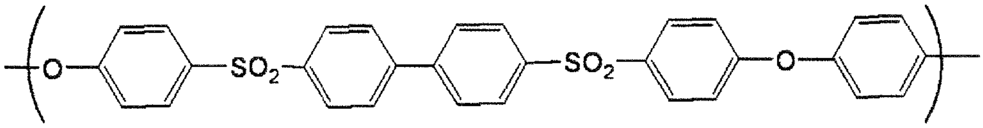
(f)

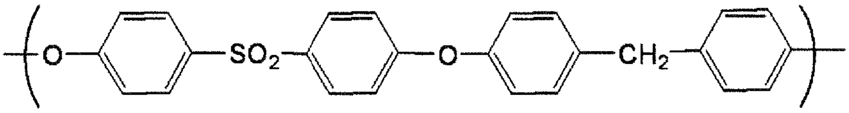
(g)

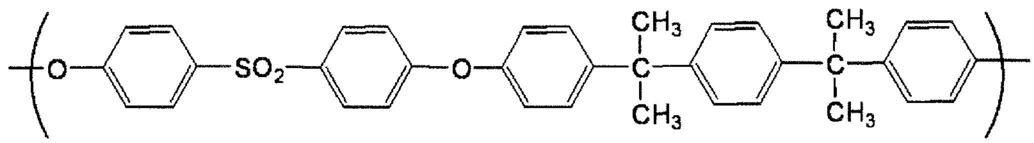
(h)

A polyethersulfone resin or a polysulfone resin is preferable as the polysulfone-based resin.

The polyallylate-based resin is a polymer compound (resin) obtained by reacting an aromatic diol with an aromatic dicarboxylic acid or a chloride thereof. The polyallylate-based resin is not particularly limited. A known polyallylate-based resin may be used.

Examples of the aromatic diol include bis(hydroxyphenyl)alkanes such as bis(4-hydroxyphenyl)methane (bisphenol F), bis(3-methyl-4-hydroxyphenyl)methane, 1,1-bis(4'-hydroxyphenyl)ethane, 1,1-bis(3'-methyl-4'-hydroxyphenyl)ethane, 2,2-bis(4'-hydroxyphenyl)propane (bisphenol A), 2,2-bis(3'-methyl-4'-hydroxyphenyl)propane, 2,2-bis(4'-hydroxyphenyl)butane, and 2,2-bis(4'-hydroxyphenyl)octane; bis(hydroxyphenyl)cycloalkanes such as 1,1-bis(4'-hydroxyphenyl)cyclopentane, 1,1 -bis(4'-hydroxyphenyl)cyclohexane (bisphenol Z), and 1,1-bis(4'-hydroxyphenyl)-3,3,5-trimethylcyclohexane; bis(hydroxyphenyl)phenylalkanes such as bis(4-hydroxyphenyl)phenylmethane, bis(3-methyl-4-hydroxyphenyl)phenylmethane, bis(2,6-dimethyl-4-hydroxyphenyl)phenylmethane, bis(2,3,6-trimethyl-4-hydroxyphenyl)phenylmethane, bis(3-t-butyl-4-hydroxyphenyl)phenylmethane, bis(3-phenyl-4-hydroxyphenyl)phenylmethane, bis(3-fluoro-4-hydroxyphenyl)phenylmethane, bis(3 -bromo-4-hydroxyphenyl)phenyl methane, bis(4-hydroxyphenyl)-4-fluorophenylmethane, bis(3-fluoro-4-hydroxyphenyl)-4-fluorophenylmethane, bi s(4-hydroxyphenyl)-4-chlorophenylmethane, bis(4-hydroxyphenyl)-4-bromophenylmethane, bis(3,5-dimethyl-4-hydroxyphenyl)-4-fluorophenylmethane, 1,1-bis(4'-hydroxyphenyl)-1-phenylethane (bisphenol P), 1,1-bis(3'-methyl-4'-hydroxyphenyl)-1-phenylethane, 1,1-bis(3'-t-butyl-4'-hydroxyphenyl)-1-phenylethane, 1,1-bis(3'-phenyl-4'-hydroxyphenyl)-1-phenylethane, 1,1-bis(4'-hydroxypheny))-1-(4'-nitrophenyl)ethane, 1,1-bis(3'-bromo-4'-hydroxyphenyt)-1-phenylethane, 1,1 -bis(4'-hydroxyphenyl)-1-phenylpropane, bis(4-hydroxyphenyl)diphenylmethane, and bis(4-hydroxyphenyl)dibenzylmethane; bis(hydroxyphenyl) ethers such as bis(4-hydroxyphenyl) ether and bis(3-methyl-4-hydroxyphenyl) ether; bis(hydroxyphenyl) ketones such as bis(4-hydroxyphenyl) ketone and bis(3-methyl-4-hydroxyphenyl) ketone; bis(hydroxyphenyl) sulfides such as bis(4-hydroxyphenyl) sulfide and bis(3-methyl-4-hydroxyphenyl) sulfide; bis(hydroxyphenyl) sulfoxides such as bis(4-hydroxyphenyl) sulfoxide and bis(3-methyl-4-hydroxyphenyl) sulfoxide; bis(hydroxyphenyl)sulfones such as bis(4-hydroxyphenyl)sulfone (bisphenol S) and bis(3-methyl-4-hydroxyphenyl)sulfone; bis(hydroxyphenyl)fluorenes such as 9,9-bis(4'-hydroxyphenyl)fluorene and 9,9-bis(3'-methyl-4'-hydroxyphenyl)fluorene; and the like.

Examples of the aromatic dicarboxylic acid or a chloride thereof include phthalic acid, isophthalic acid, terephthalic acid, 4,4'-biphenyldicarboxylic acid, diphenoxyethanedicarboxylic acid, diphenyl ether 4,4'-dicarboxylic acid, 4,4'-diphenylsulfonedicarboxylic acid, 1,5-napthalenedicarboxylic acid, 2,6-napthalenedicarboxylic acid, chlorides thereof, and the like. The polyallylate-based resin may be a modified polyallylate-based resin. A resin that includes a polymer compound obtained by reacting 2,2-bis(4'-hydroxyphenyl)propane with isophthalic acid is preferable as the polyallylate-based resin.

The term "polycarbonate-based resin" used herein refers to a polymer that includes a carbonate group (-O-C(=O)-O-) in the main chain. The polycarbonate-based resin is not particularly limited. A known polycarbonate-based resin may be used. Examples of the polycarbonate-based resin include an aromatic polycarbonate resin, an aliphatic polycarbonate resin, and the like. It is preferable to use an aromatic polycarbonate resin due to excellent heat resistance, mechanical strength, transparency, and the like.

The aromatic polycarbonate resin may be obtained by reacting an aromatic diol and a carbonate precursor using an interfacial polycondensation method or a melt transesterification method, or polymerizing a carbonate prepolymer using a solid-phase transesterification method, or polymerizing a cyclic carbonate compound using a ring-opening polymerization method.

Examples of the aromatic diol include those mentioned above in connection with the polyallylate-based resin.

Examples of the carbonate precursor include a carbonyl halide, a carbonate ester, a haloformate, and the like. Specific examples of the carbonate precursor include a dihaloformate of phosgene, a diphenyl carbonate, or a dihydric phenol, and the like.

The term "alicyclic hydrocarbon-based resin" used herein refers to a polymer that includes a cyclic hydrocarbon group in the main chain. The alicyclic hydrocarbon-based resin is not particularly limited. A known alicyclic hydrocarbon-based resin may be used. Examples of the alicyclic hydrocarbon-based resin include a monocyclic olefin-based polymer, a norbornene-based polymer, a cyclic conjugated diene-based polymer, a vinyl alicyclic hydrocarbon-based polymer, and hydrogenated products thereof. Specific examples of the alicyclic hydrocarbon-based resin include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.

These thermoplastic resins (A) may be used either alone or in combination.

Curable monomer (B)

The curable monomer (B) is a monomer includes at least one curable monomer (B) which is a polyfunctional (meth)acrylic acid derivative that includes a polymerizable unsaturated bond, and can be involved in a polymerization reaction, or a polymerization reaction and a crosslinking reaction. The term "curing" used herein is a broad concept that includes a polymerization reaction of a monomer, or a polymerization reaction of a monomer, and the subsequent crosslinking reaction of the polymer. A gas barrier film that exhibits excellent solvent resistance can be obtained by utilizing the curable monomer (B).

The molecular weight of the curable monomer (B) is normally 3000 or less, preferably 200 to 2000, and more preferably 200 to 1000.

The number of polymerizable unsaturated bonds included in the curable monomer (B) is not particularly limited. The curable monomer (B) includes at least one curable monomer (B) which is a polyfunctional (meth)acrylic acid derivative, and further additional monomer may be a monofunctional monomer that includes one polymerizable unsaturated bond, or may be a polyfunctional (e.g., bifunctional or trifunctional) monomer that includes a plurality of polymerizable unsaturated bonds.

Examples of the monofunctional monomer include a monofunctional (meth)acrylic acid derivative.

The monofunctional (meth)acrylic acid derivative is not particularly limited. A known compound may be used as the monofunctional (meth)acrylic acid derivative. Examples of the monofunctional (meth)acrylic acid derivative include a monofunctional (meth)acrylic acid derivative that includes a nitrogen atom, a monofunctional (meth)acrylic acid derivative having an alicyclic structure, a monofunctional (meth)acrylic acid derivative having a polyether structure, and the like.

Examples of the monofunctional (meth)acrylic acid derivative that includes a nitrogen atom include compounds respectively represented by the following formulas.

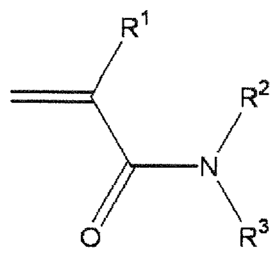

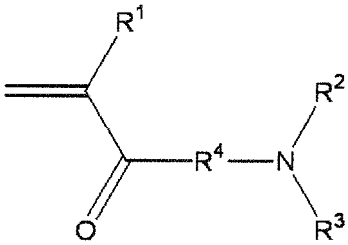

wherein $R^1$ is a hydrogen atom or an alkyl group having 1 to 6 carbon atoms, $R^2$ and $R^3$ are independently a hydrogen atom or an organic group having 1 to 12 carbon atoms, provided that $R^2$ and $R^3$ are optionally bonded to each other to form a cyclic structure, and $R^4$ is a divalent organic group.

Examples of the alkyl group having 1 to 6 carbon atoms represented by $R^1$ include a methyl group, an ethyl group, a propyl group, and the like. Among these, a methyl group is preferable.

Examples of the organic group having 1 to 12 carbon atoms represented by $R^2$ and $R^3$ include alkyl groups having 1 to 12 carbon atoms, such as a methyl group, an ethyl group, and a propyl group; cycloalkyl groups having 3 to 12 carbon atoms, such as a cyclopentyl group and a cyclohexyl group; and aromatic groups having 6 to 12 carbon atoms, such as a phenyl group, a biphenyl group, and a naphthyl group. These groups may be substituted with a substituent at an arbitrary position. $R^2$ and $R^3$ optionally bond to each other to form a ring that may include a nitrogen atom or an oxygen atom in the skeleton.

Examples of the divalent group represented by $R^4$ include groups respectively represented by $-(CH_2)_m-$ and $-NH-(CH_2)_m-$. Note that m is an integer from 1 to 10.

The monofunctional (meth)acrylic acid derivative that includes a nitrogen atom is preferably (meth)acryloylmorpholine represented by the following formula.

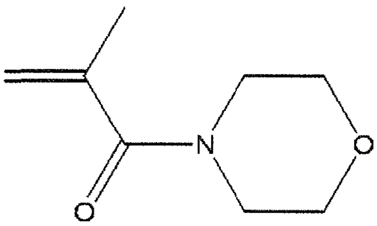

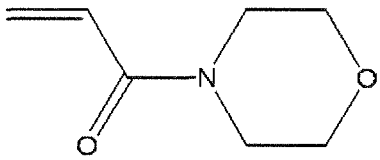

A cured resin layer that exhibits excellent heat resistance can be formed by utilizing the monofunctional (meth)acrylic acid derivative that includes a nitrogen atom.

Examples of the monofunctional (meth)acrylic acid derivative having an alicyclic structure include a compound represented by the following formula.

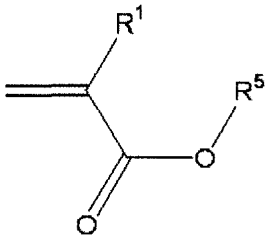

wherein $R^1$ is the same as defined above, and $R^5$ is a group having an alicyclic structure.

Examples of the group having an alicyclic structure represented by $R^5$ include a cyclohexyl group, an isobornyl group, a 1-adamantyl group, a 2-adamantyl group, a tricyclodecanyl group, and the like.

Specific examples of the monofunctional (meth)acrylic acid derivative having an alicyclic structure include isobornyl (meth)acrylate, cyclohexyl (meth)acrylate, 1 -adamantyl (meth)acrylate, 2-adamantyl (meth)acrylate, and the like.

A cured resin layer that exhibits excellent optical characteristics can be formed by utilizing the monofunctional (meth)acrylic acid derivative having an alicyclic structure.

Examples of the monofunctional (meth)acrylic acid derivative having a polyether structure include a compound represented by the following formula.

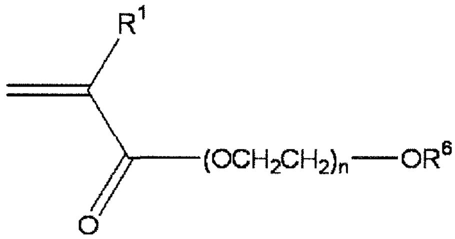

wherein $R^1$ is the same as defined above, and $R^6$ is an organic group having 1 to 12 carbon atoms. Examples of the organic group having 1 to 12 carbon atoms represented by $R^6$ include alkyl groups having 1 to 12 carbon atoms, such as a methyl group, an ethyl group, and a propyl group; cycloalkyl groups having 3 to 12 carbon atoms, such as a cyclohexyl group; aromatic groups having 6 to 12 carbon atoms, such as a phenyl group, a biphenyl group, and a naphthyl group; and the like. n is an integer from 2 to 20.

Specific examples of the monofunctional (meth)acrylic acid derivative having a polyether structure include ethoxylated o-phenylphenol (meth)acrylate, methoxy polyethylene glycol (meth)acrylate, phenoxy polyethylene glycol (meth)acrylate, and the like.

A cured resin layer that exhibits excellent toughness can be formed by utilizing the monofunctional (meth)acrylic acid derivative having a polyether structure

Examples of the polyfunctional monomer include a polyfunctional (meth)acrylic acid derivative.

The polyfunctional (meth)acrylic acid derivative is not particularly limited. A known compound may be used as the polyfunctional (meth)acrylic acid derivative. Examples of the polyfunctional (meth)acrylic acid derivative include bifunctional, trifunctional, tetrafunctional, pentafunctional, or hexafunctional (meth)acrylic acid derivatives.

Examples of the bifunctional (meth)acrylic acid derivative include a compound represented by the following formula.

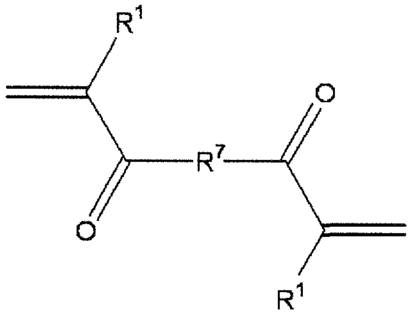

wherein $R^1$ is the same as defined above, and $R^7$ is a divalent organic group. Examples of the divalent organic group represented by $R^7$ include the groups respectively represented by the following formulas.

$-O-(CH_2)_s-O-$

$-O(CH_2CH_2O)_t-$

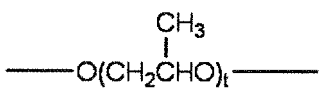

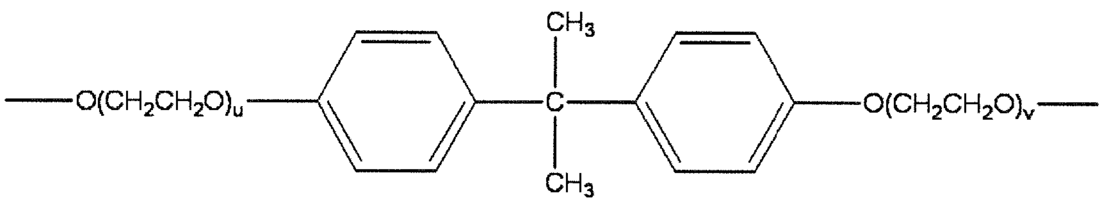

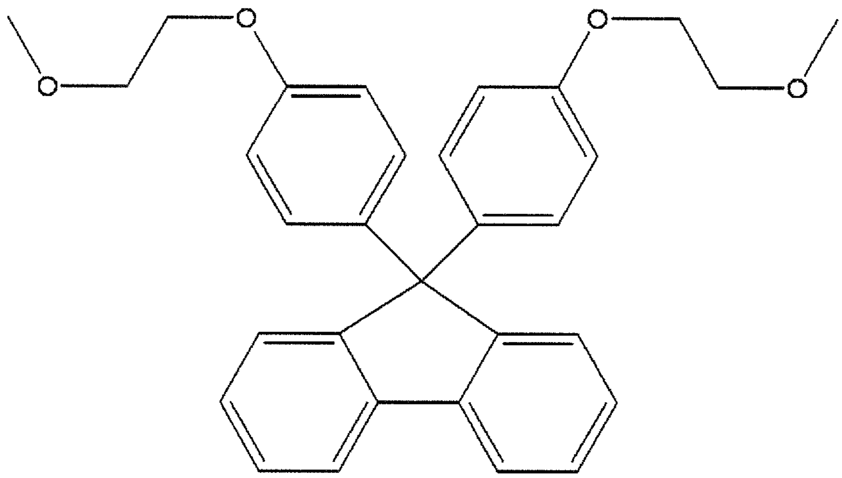

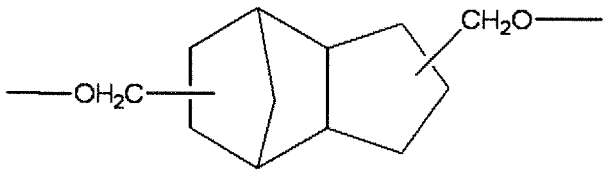

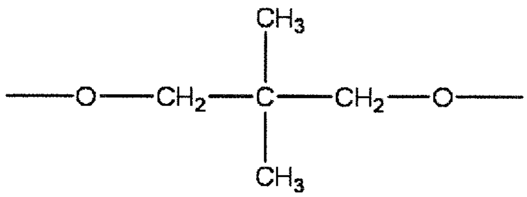

wherein s is an integer from 1 to 20, t is an integer from 1 to 30, u and v are independently an integer from 1 to 30, and "-" on each end is a bonding site.

Specific examples of the bifunctional (meth)acrylic acid derivative represented by the above formula include tricyclodecanedimethanol di(meth)acrylate, polyethylene glycol di(meth)acrylate, propoxylated-ethoxylated bisphenol A di(meth)acrylate, ethoxylated bisphenol A di(meth)acrylate, 1,10-decanediol di(meth)acrylate, 1,6-hexanediol di(meth)acrylate, 9,9-bis[4-(2-acryloyloxyethoxy)phenyl] fluorene, and the like. Among these, the bifunctional (meth)acrylic acid derivative represented by the above formula wherein the divalent organic group represented by $R^7$ has a tricyclodecane skeleton, such as tricyclodecanedimethanol di(meth)acrylate, the bifunctional (meth)acrylic acid derivative represented by the above formula wherein the divalent organic group represented by $R^7$ has a bisphenol skeleton, such as propoxylated-ethoxylated bisphenol A di(meth)acrylate and ethoxylated bisphenol A di(meth)acrylate, and the bifunctional (meth)acrylic acid derivative represented by the above formula wherein the divalent organic group represented by $R^7$ has a 9,9-bisphenylfluorene skeleton, such as 9,9-bis[4-(2-acryloyloxyethoxy)phenyl] fluorene, are preferable from the viewpoint of heat resistance and toughness.

Examples of other bifunctional (meth)acrylic acid derivatives include neopentyl glycol adipate di(meth)acrylate, hydroxy pivalate neopentyl glycol di(meth)acrylate, caprolactone-modified dicyclopentenyl di(meth)acrylate, ethylene oxide-modified phosphoric acid di(meth)acrylate, di(acryloxyethyl) isocyanurate, allylated cyclohexyl di(meth)acrylate, and the like.

Examples of the trifunctional (meth)acrylic acid derivative include trimethylolpropane tri(meth)acrylate, pentaerythritol tri(meth)acrylate, propionic acid-modified dipentaerythritol tri(meth)acrylate, propylene oxide-modified trimethylolpropane tri(meth)acrylate, tris(acryloxyethyl) isocyanurate, and the like.

Examples of the tetrafunctional (meth)acrylic acid derivative include pentaerythritol tetra(meth)acrylate and the like.

Examples of the pentafunctional (meth)acrylic acid derivative include propionic acid-modified dipentaerythritol penta(meth)acrylate and the like.

Examples of the hexafunctional (meth)acrylic acid derivative include dipentaerythritol hexa(meth)acrylate, caprolactone-modified dipentaerythritol hexa(meth)acrylate, and the like.

These curable monomers (B) may be used either alone or in combination.

The curable monomer (B) includes at least one polyfunctional (meth)acrylic acid derivative since a cured resin layer that exhibits excellent heat resistance and solvent resistance can be obtained. The polyfunctional monomer is preferably a bifunctional (meth)acrylic acid derivative due to excellent miscibility with the thermoplastic resin (A), and a capability to suppress cure shrinkage of the resulting polymer and curling of the resulting cured product. When the curable monomer (B) includes a polyfunctional monomer, the content of the polyfunctional monomer in the curable monomer (B) is preferably 40 mass% or more, and more preferably 50 to 100 mass%.

Curable resin composition

The curable resin composition used in connection with one embodiment of the invention may be prepared by mixing the thermoplastic resin (A), the curable monomer (B), an optional initiator, and an optional additional component, and dissolving or dispersing the mixture in an appropriate solvent.

The curable resin composition includes the thermoplastic resin (A) and the curable monomer (B) in a mass ratio (thermoplastic resin (A):curable monomer (B)) of 35:65 to 80:20.

When the curable resin composition includes the curable monomer (B) so that the mass ratio (thermoplastic resin (A):curable monomer (B)) is more than 30:70, the flexibility of the resulting cured resin layer may deteriorate. When the curable resin composition includes the curable monomer (B) so that the mass ratio (thermoplastic resin (A):curable monomer (B)) is less than 90:10, the solvent resistance of the resulting cured resin layer may deteriorate.

When the content of the curable monomer (B) in the curable resin composition is within the above range, the solvent can be efficiently removed when forming the cured resin layer using a solution casting method or the like, and occurrence of curling due to an increase in drying time can be prevented.

The curable resin composition used in connection with one embodiment of the invention may optionally include an initiator. The initiator is not particularly limited as long as the initiator initiates a curing reaction. Examples of the initiator include a thermal initiator and a photoinitiator.

Examples of the thermal initiator include an organic peroxide and an azo compound.

Examples of the organic peroxide include dialkyl peroxides such as di-t-butyl peroxide, t-butylcumyl peroxide, and dicumyl peroxide; diacyl peroxides such as acetyl peroxide, lauroyl peroxide, and benzoyl peroxide; ketone peroxides such as methyl ethyl ketone peroxide, cyclohexanone peroxide, 3,3,5-trimethylcyclohexanone peroxide, and methylcyclohexanone peroxide; peroxy ketals such as 1,1-bis(t-butylperoxy)cyclohexane; hydroperoxides such as t-butyl hydroperoxide, cumene hydroperoxide, 1,1,3,3-tetrametylbutyl hydroperoxide, p-menthane hydroperoxide, diisopropylbenzene hydroperoxide, and 2,5-dimethylhexane-2,5-dihydroperoxide; peroxy esters such as t-butylperoxy acetate, t-butyl peroxy-2-ethylhexanoate, t-butyl peroxybenzoate, and t-butyl peroxyisopropylcarbonate; and the like.

Examples of the azo compound include 2,2'-azobis(4-methoxy-2,4-dimethylvaleronitrile), 2,2'-azobis(2-cyclopropylpropionitrile), 2,2'-azobis(2,4-dimethylvaleronitrile), azobisisobutyronitrile, 2,2'-azobis(2-methylbutyronitrile), 1,1'-azobis(cyclohexane-1-carbonitrile), 2-(carbamoylazo)isobutyronitrile, 2-phenylazo-4-methoxy-2,4-dimethylvaleronitrile, and the like.

Examples of the photoinitiator include alkylphenone-based photoinitiators such as 2,2-dimethoxy-1,2-diphenylethane-1-one, 1-hydroxycyclohexyl phenyl ketone, 2-hydroxy-2-methyl-1 -phenylpropan-1 -one, 1-[4-(2-hydroxyethoxy)-phenyl]-2-hydroxy-2-methyl-1-propan-1-one, 2-hydroxy-1-[4-[4-(2-hydroxy-2-methylpropionyl)benzyl]phenyl]-2-methylpropan- 1-on e, 2-methyl-1-(4-methylthiophenyl)-2-morpholinopropan-1-one, 2-benzyl-2-dimethylamino-1-(4-morpholinophenyl)butanone-1, and 2-(dimethylamino)-2-[(4-methylphenyl)methyl]-1-[4-(4-norpholinyl)phenyl]-1-butanon e; phosphorus-based photoinitiators such as 2,4,6-trimethylbenzoyldiphenylphosphine oxide, bis(2,4,6-trimethylbenzoyl)phenylphosphine oxide, ethyl(2,4,6-trimethylbenzoyl)phenyl phosphinate, and bis(2,6-dimethoxybenzoyl)-2,4,4-trimethylpentylphosphine oxide; titanocene-based photoinitiators such as bis($\eta^5$-2,4-cyclopentadien-1-yl)-bis[2,6-difluoro-3-(1H-pyrrol-1-yl)-phenyl]titanium; oxime ester-based photoinitiators such as 1,2-octanedione-1-[4-(phenylthio)-2-(O-benzoyloxime)] and ethanone-1-[9-ethyl-6-(2-methylbenzoyl)-9H-carbazol-3-yl]-1-(O-acetyloxime); benzophenone-based photoinitiators such as benzophenone, p-chlorobenzophenone, benzoylbenzoic acid, methyl o-benzoylbenzoate, 4-methylbenzophenone, 4-phenylbenzophenone, hydroxybenzophenone, acrylated benzophenone, 4-benzoyl-4'-methyldiphenyl sulfide, 3,3 '-dimethyl-4-methoxybenzophenone, 2,4,6-trimethylbenzophenone, and 4-(13-acryloyl-1 ,4,7,10,13-pentaoxatridecyl)benzophenone; thioxanthone-based photo initiators such as thioxanthone, 2-chlorothioxanthone, 3-methylthioxanthone, 2,4-dimethylthioxanthone, 2,4-diisopropylthioxanthone, 2,4-dichlorothioxanthone, 1-chloro-4-propoxythioxanthone, 2-methylthioxanthone, 2-isopropylthioxanthone, and 4-isopropylthioxanthone; and the like.

Among these, the phosphorus-based photoinitiators such as 2,4,6-trimethylbenzoyldiphenylphosphine oxide, bis(2,4,6-trimethylbenzoyl)phenylphosphine oxide, ethyl(2,4,6-trimethylbenzoyl)phenyl phosphinate, and bis(2,6-dimethoxybenzoyl)-2,4,4-trimethylpentylphosphine oxide are preferable.

When the thermoplastic resin (A) is a thermoplastic resin that includes an aromatic ring, the thermoplastic resin

(A) may absorb ultraviolet rays, and a curing reaction may occur to only a small extent. When the initiator is a phosphorus-based photoinitiator, however, a curing reaction can be efficiently effected by utilizing light having a wavelength that is not absorbed by the thermoplastic resin (A).

These initiators may be used either alone or in combination.

The content of the initiator in the curable resin composition is preferably 0.05 to 15 mass%, more preferably 0.05 to 10 mass%, and still more preferably 0.05 to 5 mass%.

The curable resin composition may include a photopolymerization promoter such as triisopropanolamine or 4,4'-diethylaminobenzophenone in addition to the thermoplastic resin (A), the curable monomer (B), and the initiator.

The solvent used to prepare the curable resin composition is not particularly limited. Examples of the solvent include aliphatic hydrocarbon-based solvents such as n-hexane and n-heptane; aromatic hydrocarbon-based solvents such as toluene and xylene; halogenated hydrocarbon-based solvents such as dichloromethane, ethylene chloride, chloroform, carbon tetrachloride, 1,2-dichloroethane, and monochlorobenzene; alcohol-based solvents such as methanol, ethanol, propanol, butanol, and propylene glycol monomethyl ether; ketone-based solvents such as acetone, methyl ethyl ketone, 2-pentanone, isophorone, and cyclohexanone; ester-based solvents such as ethyl acetate and butyl acetate; cellosolve-based solvents such ethylcellosolve; ether-based solvents such as 1,3-dioxolane; and the like.

The content of the solvent in the curable resin composition is not particularly limited. The solvent is normally used in an amount of 0.1 to 1000 g, and preferably 1 to 100 g, based on 1 g of the thermoplastic resin (A). The viscosity of the curable resin composition can be appropriately adjusted by appropriately adjusting the amount of the solvent.

The curable resin composition may further include a known additive such as a plasticizer, an antioxidant, or a UV absorber as long as the object and the advantageous effects of the invention are not impaired.

The curable resin composition may be cured by an appropriate method depending on the type of initiator and the type of curable monomer. The details thereof are described later in connection with a method for producing a gas barrier film according to one embodiment of the invention.

Cured resin layer

The thickness of the cured resin layer included in the gas barrier film according to one embodiment of the invention is not particularly limited, and may be determined depending on the application (object) of the gas barrier film. The thickness of the cured resin layer is normally 0.5 to 300 μm, preferably 1 to 300 μm, more preferably 2 to 200 μm, still more preferably 3 to 100 μm, and particularly preferably 5 to 20 μm.

The cured resin layer exhibits excellent heat resistance. The glass transition temperature (Tg) of the cured resin layer is normally 140°C or more, and preferably 150°C or more. A gas barrier film that exhibits excellent heat resistance can be obtained when the glass transition temperature (Tg) of the cured resin layer is 140°C or more.

The cured resin layer exhibits excellent solvent resistance. Since the cured resin layer exhibits excellent solvent resistance, the surface of the cured resin layer is dissolved to only a small extent even if an organic solvent is used when forming an additional layer on the surface of the cured resin layer, for example. Therefore, the components of the cured resin layer are not easily mixed into the gas barrier layer even if the gas barrier layer is formed on the surface of the cured resin layer using a resin solution that includes an organic solvent, for example. This suppresses a deterioration in gas barrier capability.

The gel fraction of the cured resin layer is preferably 90% or more, and more preferably 94% or more, from the above viewpoint. Since the cured resin layer having a gel fraction of 90% or more exhibits excellent solvent resistance, the surface of the cured resin layer is dissolved to only a small extent even if an organic solvent is used when forming an additional layer on the surface of the cured resin layer, and a gas barrier film that exhibits excellent solvent resistance can be obtained.

The gel fraction is determined as described below. Specifically, the cured resin layer is cut to have dimensions of 100×100 mm, wrapped with a nylon mesh (#120) (150×150 mm of which the mass has been measured in advance), immersed in toluene (100 mL) for 3 days, removed, dried at 120°C for 1 hour, and allowed to stand at a temperature of 23°C and a relative humidity of 50% for 3 hours. The mass of the cured resin layer is then measured, and the gel fraction is calculated by the following expression.

$$\text{Gel fraction (\%)} = [(\text{weight of residual resin after immersion}) / (\text{weight of resin before immersion})] \times 100$$

The cured resin layer included in the gas barrier film according to one embodiment of the invention exhibits excellent interlayer adhesion to the gas barrier layer. Specifically, the gas barrier layer can be formed on the cured resin layer without providing an anchor coating layer.

It is preferable that the cured resin layer included in the gas barrier film according to one embodiment of the invention be colorless and transparent. When the cured resin layer is colorless and transparent, the gas barrier film according to one embodiment of the invention can preferably be used in optical applications.

The cured resin layer included in the gas barrier film according to one embodiment of the invention has a low birefringence, and exhibits excellent optical isotropy. The in-plane retardation of the cured resin layer is normally 20 nm or less, and preferably 15 nm or less. The retardation of the cured resin layer in the thickness direction is normally -500 nm or less, and preferably -450 nm or less. A value (birefringence) obtained by dividing the in-plane retardation by the thickness of the cured resin layer is normally $100\times10^{-5}$ or less, and preferably $20\times10^{-5}$ or less.

When the in-plane retardation, the retardation in the thickness direction, and the birefringence of the cured resin layer are respectively within the above ranges, a gas barrier film that has a low birefringence, and exhibits excellent optical isotropy is obtained. Therefore, the gas barrier film according to one embodiment of the invention can preferably be used in optical applications.

The cured resin layer included in the gas barrier film according to one embodiment of the invention exhibits excellent heat resistance, excellent solvent resistance, excellent interlayer adhesion, and excellent transparency, has a low birefringence, and exhibits excellent optical isotropy. Therefore, a gas barrier film that exhibits excellent heat resistance, excellent solvent resistance, excellent interlayer adhesion, and excellent transparency, has a low birefringence, and exhibits excellent optical isotropy can be obtained by forming the gas barrier layer on the cured resin layer having the above characteristics using a solution casting method, for example (described later).

(II) Gas barrier layer

A material for forming the gas barrier layer included in the gas barrier film according to one embodiment of the invention and the like are not particularly limited as long as the gas barrier layer exhibits a gas barrier capability. Examples of the gas barrier layer include a gas barrier layer that is formed of an inorganic film, a gas barrier layer that includes a gas barrier resin, a gas barrier layer obtained by implanting ions into a layer that includes a polymer compound, and the like.

It is preferable that the gas barrier layer be a gas barrier layer that is formed of an inorganic film, or a gas barrier layer obtained by implanting ions into a layer that includes a polymer compound, since it is possible to efficiently form a layer that is thin, and exhibits an excellent gas barrier capability.

The inorganic film is not particularly limited. Examples of the inorganic film include an inorganic deposited film.

Examples of the inorganic deposited film include a film obtained by depositing an inorganic compound, and a film obtained by depositing a metal.

Examples of the inorganic compound used as a raw material for forming the inorganic deposited film include inorganic oxides such as silicon oxide, aluminum oxide, magnesium oxide, zinc oxide, indium oxide, and tin oxide; inorganic nitrides such as silicon nitride, aluminum nitride, and titanium nitride; inorganic carbides; inorganic sulfides; inorganic oxynitrides such as silicon oxynitride; inorganic oxycarbides; inorganic carbonitrides; inorganic oxycarbonitrides; and the like.

Examples of the metal used as a raw material for forming the inorganic deposited film include aluminum, magnesium, zinc, tin, and the like.

These materials may be used either alone or in combination.

An inorganic deposited film formed using an inorganic oxide, an inorganic nitride, or a metal as the raw material is preferable from the viewpoint of gas barrier capability. An inorganic deposited film formed using an inorganic oxide or an inorganic nitride as the raw material is preferable from the viewpoint of transparency. The inorganic deposited film may be a single-layer film, or may be a multilayer film.

The thickness of the inorganic deposited film is preferably 10 to 2000 nm, more preferably 20 to 1000 nm, still more preferably 30 to 500 nm, and yet more preferably 40 to 200 nm, from the viewpoint of gas barrier capability and handling capability.

The inorganic deposited film may be formed by a physical vapor deposition (PVD) method such as a vacuum deposition method, a sputtering method, or an ion plating method, or a chemical vapor deposition (CVD) method such as a thermal CVD method, a plasma CVD method, or a photo-CVD method, for example.

Examples of the gas barrier resin include resins that allow oxygen and the like to pass through to only a small extent, such as polyvinyl alcohol, a partially saponified product thereof, an ethylene-vinyl alcohol copolymer, polyacrylonitrile, polyvinyl chloride, polyvinylidene chloride, and polychlorotrifluoroethylene.

The thickness of the gas barrier layer that includes the gas barrier resin is preferably 10 to 2000 nm, more preferably 20 to 1000 nm, still more preferably 30 to 500 nm, and yet more preferably 40 to 200 nm, from the viewpoint of gas barrier capability.

The gas barrier layer that includes the gas barrier resin may be formed by applying a solution that includes the gas barrier resin to the cured resin layer to form a film, and appropriately drying the film.

Examples of the polymer compound used when forming the gas barrier layer by implanting ions into a layer

that includes a polymer compound (hereinafter may be referred to as "polymer layer") include silicon-containing polymer compounds, polyimides, polyamides, polyamideimides, polyphenylene ethers, polyether ketones, polyether ether ketones, polyolefins, polyesters, polycarbonates, polysulfones, polyether sulfones, polyphenylene sulfides, polyallylates, acrylic resins, cycloolefin-based polymers, aromatic polymers, and the like. These polymer compounds may be used either alone or in combination.

Among these, a silicon-containing polymer compound is preferable as the polymer compound. Examples of the silicon-containing polymer compound include a polysilazane-based compound (see JP-B-63-16325, JP-A-62-195024, JP-A-63-81122, JP-A-1-138108, JP-A-2-84437, JP-A-2-175726, JP-A-4-63833, JP-A-5-238827, JP-A-5-345826, JP-A-2005-36089, JP-A-6-122852, JP-A-6-299118, JP-A-6-306329, JP-A-9-31333, JP-A-10-245436, JP-T-2003-514822, and WO2011/107018, for example), a polycarbosilane-based compound (see Journal of Materials Science, 2569-2576, Vol. 13, 1978, Organometallics, 1336-1344, Vol. 10, 1991, Journal of Organometallic Chemistry, 1-10, Vol. 521, 1996, JP-A-51-126300, JP-A-2001-328991, JP-A-2006-117917, JP-A-2009-286891, and JP-A-2010-106100, for example), a polysilane-based compound (see R.D. Miller, J. Michl; Chemical Review, Vol. 89, p. 1359 (1989), N. Matsumoto; Japanese Journal of Physics, Vol. 37, p. 5425 (1998), JP-A-2008-63586, and JP-A-2009-235358, for example), a polyorganosiloxane-based compound (see JP-A-2010-229445, JP-A-2010-232569, and JP-A-2010-238736, for example), and the like.

Among these, a polysilazane-based compound is preferable since a gas barrier layer that exhibits an excellent gas barrier capability can be formed. Examples of the polysilazane-based compound include an inorganic polysilazane and an organic polysilazane. Examples of the inorganic polysilazane include perhydropolysilazane and the like. Examples of the organic polysilazane include a compound obtained by substituting some or all of the hydrogen atoms of perhydropolysilazane with an organic group such as an alkyl group, and the like. It is preferable to use an inorganic polysilazane due to availability, and a capability to form a gas barrier layer that exhibits an excellent gas barrier capability.

A product commercially available as a glass coating material or the like may be used directly as the polysilazane-based compound.

These polysilazane-based compounds may be used either alone or in combination.

The polymer layer may include an additional component other than the polymer compound as long as the object of the invention is not impaired. Examples of the additional component include a curing agent, an additional polymer, an aging preventive, a light stabilizer, a flame retardant, and the like.

The content of the polymer compound in the polymer layer is preferably 50 mass% or more, and more preferably 70 mass% or more, from the viewpoint of forming a gas barrier layer that exhibits an excellent gas barrier capability.

The polymer layer may be formed by applying a layer-forming solution that includes at least one polymer compound, an optional additional component, a solvent, and the like to the cured resin layer or a primer layer optionally formed on the cured resin layer using a known method, and appropriately drying the resulting film, for example.

A spin coater, a knife coater, a gravure coater, or the like may be used to apply the layer-forming solution.

It is preferable to heat the resulting film in order to dry the film, and improve the gas barrier capability of the resulting gas barrier film. The film may be heated and dried using a known drying method such as hot-air drying, heat roll drying, or infrared irradiation. The heating temperature is normally 80 to 150°C. The heating time is normally several tens of seconds to several tens of minutes.

The thickness of the polymer layer is normally 20 to 1000 nm, preferably 30 to 500 nm, and more preferably 40 to 200 nm.

According to one embodiment of the invention, a film that exhibits a sufficient gas barrier capability can be obtained by implanting ions as described below, even when the polymer layer has a thickness at a nanometer level.

The dose of ions implanted into the polymer layer may be appropriately determined depending on the intended use of the resulting film (e.g., desired gas barrier capability and transparency), and the like.

Examples of the ions implanted into the polymer layer include ions of a rare gas such as argon, helium, neon, krypton, or xenon; ions of a fluorocarbon, hydrogen, nitrogen, oxygen, carbon dioxide, chlorine, fluorine, sulfur, or the like; ions of an alkane gas such as methane, ethane, propane, butane, pentane, or hexane; ions of an alkene gas such as ethylene, propylene, butene, or pentene; ions of an alkadiene gas such as pentadiene or butadiene; ions of an alkyne gas such as acetylene or methylacetylene; ions of an aromatic hydrocarbon gas such as benzene, toluene, xylene, indene, naphthalene, or phenanthrene; ions of a cycloalkane gas such as cyclopropane or cyclohexane; ions of a cycloalkene gas such as cyclopentene or cyclohexene; ions of a conductive metal such as gold, silver, copper, platinum, nickel, palladium, chromium, titanium, molybdenum, niobium, tantalum, tungsten, or aluminum; ions of silane ($SiH_4$) or an organosilicon compound; and the like.

Examples of the organosilicon compounds include tetraalkoxysilanes such as tetramethoxysilane, tetraethoxysilane, tetra-n-propoxysilane, tetraisopropoxysilane, tetra-n-butoxysilane, and tetra-t-butoxysilane; substituted or unsubstituted alkylalkoxysilanes such as dimethyldimethoxysilane, dimethyldiethoxysilane, diethyldimethoxysilane, methyltriethoxysilane, ethyltrimethoxysilane, and (3,3,3-trifluoropropyl)trimethoxysilane; arylalkoxysilanes such as diphenyldimethoxysilane and phenyltriethoxysilane; disiloxanes such as hexamethyldisiloxane (HMDSO); aminosilanes such as

bis(dimethylamino)dimethylsilane, bis(dimethylamino)methylvinylsilane, bis(ethylamino)dimethylsilane, diethylaminotrimethylsilane, dimethylaminodimethylsilane, tetrakisdimethylaminosilane, and tris(dimethylamino)silane; silazanes such as hexamethyldisilazane, hexamethylcyclotrisilazane, heptamethyldisilazane, nonamethyltrisilazane, octamethylcyclotetrasilazane, and tetramethyldisilazane; cyanatosilanes such as tetraisocyanatosilane; halogenosilanes such as triethoxyfluorosilane; alkenylsilanes such as diallyldimethylsilane and allyltrimethylsilane; substituted or unsubstituted alkylsilanes such as di-t-butylsilane, 1,3-disilabutane, bis(trimethylsilyl)methane, tetramethylsilane, tris(trimethylsilyl)methane, tris(trimethylsilyl)silane, and benzyltrimethylsilane; silylalkynes such as bis(trimethylsilyl)acetylene, trimethylsilylacetylene, and 1-(trimethylsilyl)-1-propyne; silylalkenes such as 1,4-bistrimetbylsilyl-1 ,3-butadiyne and cyclopentadienyltrimethylsilane; arylalkylsilanes such as phenyldimethylsilane and phenyltrimethylsilane; alkynylalkylsilanes such as propargyltrimethylsilane; alkenylalkylsilanes such as vinyltrimethylsilane; disilanes such as hexamethyldisilane; siloxanes such as octamethylcyclotetrasiloxane, tetramethylcyclotetrasiloxane, and hexamethylcyclotetrasiloxane; N,O-bis(trimethylsilyl)acetamide; bis(trimethylsilyl)carbodiimide; and the like.

These compounds (ions) may be used either alone or in combination.

It is preferable to use ions of at least one element selected from the group consisting of hydrogen, nitrogen, oxygen, argon, helium, neon, xenon, and krypton from the viewpoint of ease of implantation and a capability to form a gas barrier layer that exhibits a particularly excellent gas barrier capability.

The ions may be implanted using an arbitrary method. For example, the ions may be implanted by applying ions (ion beams) accelerated by an electric field, implanting ions present in plasma (plasma ion implantation method), or the like. It is preferable to use the plasma ion implantation method since a gas barrier film can be easily obtained.

It is preferable to use a plasma ion implantation method ($\alpha$) that implants ions present in plasma generated by utilizing an external electric field into the polymer layer, or a plasma ion implantation method ($\beta$) that implants ions present in plasma generated due to an electric field produced by applying a negative high-voltage pulse to the polymer layer into the polymer layer.

When using the method ($\alpha$), it is preferable to set the ion implantation pressure (plasma ion implantation pressure) to 0.01 to 1 Pa. When the ion implantation pressure is within the above range, ions can be easily, efficiently, and uniformly implanted, and the desired gas barrier layer can be efficiently formed.

The method ($\beta$) does not require a high degree of decompression, allows an easy operation, and significantly reduces the processing time. Moreover, the entire polymer layer can be uniformly processed, and ions present in plasma can be continuously implanted into the polymer layer with high energy when applying a negative high-voltage pulse. The method ($\beta$) also has an advantage in that ions can be uniformly implanted into the polymer layer by merely applying a negative high-voltage pulse to the polymer layer without requiring a special means such as a high-frequency power supply (e.g., radio frequency (RF) power supply or microwave power supply).

When using the method ($\alpha$) or ($\beta$), the pulse width when applying a negative high-voltage pulse (i.e., during ion implantation) is preferably 1 to 15 $\mu$s. When the pulse width is within the above range, ions can be easily, efficiently, and uniformly implanted.

The applied voltage when generating plasma is preferably -1 to -50 kV, more preferably -1 to -30 kV, and particularly preferably -5 to -20 kV. If the applied voltage is higher than -1 kV, the ion implantation dose may be insufficient, and the desired performance may not be obtained. If the applied voltage is lower than -50 kV, the film may be charged during ion implantation, or coloration or the like may occur.

Examples of the ion species used for plasma ion implantation include those mentioned above.

A plasma ion implantation apparatus is used when implanting ions present in plasma into the polymer layer.

Specific examples of the plasma ion implantation apparatus include (i) an apparatus that causes the polymer layer (hereinafter may be referred to as "ion implantation target layer") to be evenly enclosed by plasma by superimposing high-frequency electric power on a feed-through that applies a negative high-voltage pulse to the ion implantation target layer so that ions present in the plasma are attracted to and collide with the target, and thereby implanted and deposited therein (JP-A-2001-26887), (ii) an apparatus that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and implanted into the target while heating the ion implantation target layer, causing electrons present in the plasma to be attracted to and collide with the target due to the positive pulse, and applying the negative pulse while controlling the temperature by controlling the pulse factor (JP-A-2001 -156013), (iii) a plasma ion implantation apparatus that generates plasma using an external electric field utilizing a high-frequency electric power supply such as a microwave power supply, and causes ions present in the plasma to be attracted to and implanted into the target by applying a high-voltage pulse, (iv) a plasma ion implantation apparatus that implants ions present in plasma generated due to an electric field produced by applying a high-voltage pulse without using an external electric field, and the like.

It is preferable to use the plasma ion implantation apparatus (iii) or (iv) since the plasma ion implantation apparatus (iii) or (iv) allows a simple operation, significantly reduces the processing time, and can be continuously used.

WO2010/021326 discloses a method that utilizes the plasma ion implantation apparatus (iii) or (iv).

Since the plasma ion implantation apparatus (iii) or (iv) is configured so that the high-voltage pulse power supply is used as a plasma generation means that generates plasma, ions present in plasma can be continuously implanted into the polymer layer by merely applying a negative high-voltage pulse to the polymer layer without requiring a special means such as a high-frequency power supply (e.g., radio frequency (RF) power supply or microwave power supply), and a gas barrier film including a polymer layer having a surface area modified by ion implantation (i.e., gas barrier film) can be mass-produced.

The thickness of the ion implantation target area may be controlled by adjusting the implantation conditions (e.g., type of ions, applied voltage, and implantation time), and may be determined depending on the thickness of the polymer layer, the intended use of the gas barrier film, and the like. The thickness of the ion implantation target area is normally 5 to 1000 nm.

Whether or not ions have been implanted may be determined by performing elemental analysis on a surface area of the polymer layer having a depth up to about 10 nm using X-ray photoelectron spectroscopy (XPS).

The gas barrier layer exhibits a gas barrier capability since the gas barrier layer has a low water vapor transmission rate.

The water vapor transmission rate of the gas barrier layer at a temperature of 40°C and a relative humidity of 90% is 1 $g/m^2$/day or less, preferably 0.8 $g/m^2$/day or less, more preferably 0.5 $g/m^2$/day or less, and still more preferably 0.1 $g/m^2$/day or less. The water vapor transmission rate may be measured using a known method.

(III) Gas barrier film

The gas barrier film according to one embodiment of the invention includes the cured resin layer and the gas barrier layer, the gas barrier layer being provided on at least one side of the cured resin layer. The gas barrier film according to one embodiment of the invention may include one cured resin layer and one gas barrier layer, or may include two or more cured resin layers and/or gas barrier layers.

FIG. 1 illustrates examples of the gas barrier film according to one embodiment of the invention (see (a) and (b)).

A gas barrier film (10) illustrated in FIG. 1 (see (a)) includes a cured resin layer (1), and a gas barrier layer (2) that is provided on one side of the cured resin layer (1).

A gas barrier film (20) illustrated in FIG. 1 (see (b)) includes a cured resin layer (1), a gas barrier layer (2'), and a gas barrier layer (2"), the gas barrier layer (2') and the gas barrier layer (2") being provided on either side of the cured resin layer (1).

Note that the gas barrier film according to one embodiment of the invention is not limited to the examples illustrated in FIG. 1 (see (a) and (b)). The gas barrier film according to one embodiment of the invention may further include one additional layer or two or more additional layers as long as the object of the invention is not impaired.

Examples of the additional layer include a conductive layer, an impact-absorbing layer, an adhesive layer, a bonding layer, a process sheet, and the like. The position of the additional layer is not particularly limited.

Examples of a material for forming the conductive layer include metals, alloys, metal oxides, electrically conductive compounds, mixtures thereof, and the like. Specific examples of the material for forming the conductive layer include antimony-doped tin oxide (ATO); fluorine-doped tin oxide (FTO); semiconductive metal oxides such as tin oxide, germanium-doped zinc oxide (GZO), zinc oxide, indium oxide, indium tin oxide (ITO), and indium zinc oxide (IZO); metals such as gold, silver, chromium, and nickel; mixtures of these metals and a conductive metal oxide; inorganic conductive substances such as copper iodide and copper sulfide; organic conductive materials such as polyaniline, polythiophene, and polypyrrole; and the like.

The conductive layer may be formed using an arbitrary method. For example, the conductive layer may be formed by an evaporation (deposition) method, a sputtering method, an ion plating method, a thermal CVD method, a plasma CVD method, or the like.

The thickness of the conductive layer may be appropriately selected depending on the application and the like. The thickness of the conductive layer is normally 10 nm to 50 μm, and preferably 20 nm to 20 μm.

The impact-absorbing layer protects the gas barrier layer when an impact is applied to the gas barrier layer. A material for forming the impact-absorbing layer is not particularly limited. Examples of the material for forming the impact-absorbing layer include acrylic-based resins, urethane-based resins, silicone-based resins, olefin-based resins, rubber-based materials, and the like.

The impact-absorbing layer may be formed using an arbitrary method. For example, the impact-absorbing layer may be formed by applying an impact-absorbing layer-forming solution that includes the material for forming the impact-absorbing layer and an optional component (e.g., solvent) to the layer on which the impact-absorbing layer is to be formed, drying the resulting film, and optionally heating the dried film.

Alternatively, the impact-absorbing layer may be formed on a release base, and transferred to the layer on which the impact-absorbing layer is to be formed.

The thickness of the impact-absorbing layer is normally 1 to 100 μm, and preferably 5 to 50 μm.

The adhesive layer is used when bonding the gas barrier film according to one embodiment of the invention to an adherend. A material for forming the adhesive layer is not particularly limited. Examples of the material for forming the adhesive layer include a known adhesive or pressure-sensitive adhesive (e.g., acrylic-based adhesive or pressure-sensitive adhesive, silicone-based adhesive or pressure-sensitive adhesive, and rubber-based adhesive or pressure-sensitive adhesive), a heat sealing material, and the like.

The bonding layer is used when bonding a plurality of gas barrier films according to one embodiment of the invention to produce a gas barrier film laminate, for example. The details of the bonding layer are described later in connection with a gas barrier film laminate.

The process sheet protects the cured resin layer, the gas barrier layer, and the additional layer during storage, transportation, or the like. The process sheet is removed in a specific step.

When the gas barrier film includes the process sheet, the gas barrier film may include the process sheet on one side or both sides thereof. In the latter case, it is preferable that one of the process sheets that is to be removed before the other be designed to be more easily removed.

It is preferable that the process sheet have a sheet-like shape or a film-like shape. The sheet-like or film-like process sheet need not necessarily be a long process sheet, but may be a short flat process sheet.

Examples of the process sheet include a paper substrate such as glassine paper, coated paper, and high-quality paper; laminated paper prepared by laminating a thermoplastic resin (e.g., polyethylene or polypropylene) on a paper substrate; a paper substrate that is sealed with cellulose, starch, polyvinyl alcohol, an acrylic styrene resin, or the like; a plastic film such as a polyester film (e.g., polyethylene terephthalate, polybutylene terephthalate, or polyethylene naphthalate) and a polyolefin film (e.g., polyethylene or polypropylene); glass; and the like.

The process sheet may have a configuration in which a release agent layer is provided on a paper substrate or a plastic film from the viewpoint of ease of handling. The release layer may be formed using a known release agent (e.g., silicone-based release agent, fluorine-based release agent, alkyd-based release agent, or olefin-based release agent).

The thickness of the release agent layer is not particularly limited, but is normally 0.02 to 2.0 μm, and preferably 0.05 to 1.5 μm.

The thickness of the process sheet is preferably 1 to 500 μm, and more preferably 5 to 300 μm, from the viewpoint of ease of handling.

The surface roughness Ra (arithmetic average roughness) of the process sheet is preferably 10.0 nm or less, and more preferably 8.0 nm or less. The surface roughness Rt (maximum roughness height) of the process sheet is preferably 100 nm or less, and more preferably 50 nm or less.

When the surface roughness Ra exceeds 10.0 nm, and/or the surface roughness Rt exceeds 100 nm, the surface roughness of the layer that comes in contact with the process sheet may increase, and the gas barrier capability of the gas barrier film may deteriorate.

The surface roughness Ra and the surface roughness Rt refer to values measured by optical interferometry (measurement area: 100×100 μm).

The thickness of the gas barrier film according to one embodiment of the invention may be appropriately determined depending on the application of the target electronic device, for example. The substantial thickness of the gas barrier film according to one embodiment of the invention is preferably 1 to 300 μm, more preferably 2 to 200 μm, and still more preferably 3 to 100 μm, from the viewpoint of handling capability.

The term "substantial thickness" used herein refers to the thickness of the gas barrier film in a usage state. Specifically, the gas barrier film according to one embodiment of the invention may include the process sheet or the like, and the thickness of the part (e.g., process sheet) that is removed before use is excluded from the substantial thickness.

Since the gas barrier film according to one embodiment of the invention includes the cured resin layer and the gas barrier layer, the gas barrier film according to one embodiment of the invention exhibits excellent heat resistance, excellent solvent resistance, excellent interlayer adhesion, and an excellent gas barrier capability, has a low birefringence, and exhibits excellent optical isotropy.

The water vapor transmission rate of the gas barrier film according to one embodiment of the invention at a temperature of 40°C and a relative humidity of 90% is 1 $g/m^2$/day or less, preferably 0.8 $g/m^2$/day or less, more preferably 0.5 $g/m^2$/day or less, and still more preferably 0.1 $g/m^2$/day or less.

2) Method for producing gas barrier film

The gas barrier film according to one embodiment of the invention may be produced using an arbitrary method. It is preferable to produce the gas barrier film according to one embodiment of the invention using a method that utilizes a process sheet since the gas barrier film can be efficiently and easily produced. It is more preferable to produce the gas barrier film according to one embodiment of the invention using a method that includes the following steps 1 to 3.

Step 1: A step that forms a curable resin layer on a process sheet, the curable resin layer being formed of a curable resin composition that includes (A) a thermoplastic resin having a glass transition temperature (Tg) of 140°C or more, and (B) a curable monomer.

Step 2: A step that cures the curable resin layer obtained by the step 1 to form a cured resin layer.

Step 3: A step that forms a gas barrier layer on the cured resin layer obtained by the step 2.

Step 1

In the step 1, the curable resin layer is formed on the process sheet, the curable resin layer being formed of the curable resin composition that includes the thermoplastic resin (A) having a glass transition temperature (Tg) of 140°C or more, and the curable monomer (B).

Examples of the process sheet and the curable resin composition include those mentioned above.

The curable resin composition may be applied to the process sheet using an arbitrary method. For example, a known coating method such as a spin coating method, a spray coating method, a bar coating method, a knife coating method, a roll coating method, a blade coating method, a die coating method, or a gravure coating method may be used.

A film formed by applying the curable resin composition may be dried using an arbitrary method. For example, a known drying method such as hot-air drying, heat roll drying, or infrared irradiation may be used. Since the curable resin composition used in connection with one embodiment of the invention includes the curable monomer (B) in addition to the thermoplastic resin (A) having a very high glass transition temperature (Tg), the solvent can be efficiently removed when drying the film obtained using a solution casting method.

The drying temperature employed when drying the film is normally 30 to 150°C, and preferably 50 to 100°C.

The thickness of the dry film (curable resin layer) is not particularly limited. The thickness of the dry film is normally 0.5 to 300 μm, preferably 1 to 300 μm, and still more preferably 3 to 100 μm. The thickness of the curable resin layer is normally 0.5 to 300 μm, preferably 2 to 200 μm, more preferably 1 to 300 μm, and particularly preferably 5 to 20 μm.

Step 2

In the step 2, the curable resin layer obtained by the step 1 is cured to form a cured resin layer.

The curable resin layer may be cured using an arbitrary method. A known method may be used. For example, when the curable resin layer is formed using a curable resin composition that includes a thermal initiator, the curable resin layer can be cured by heating the curable resin layer. The heating temperature is normally 30 to 150°C, and preferably 50 to 100°C.

When the curable resin layer is formed using a curable resin composition that includes a photoinitiator, the curable resin layer can be cured by applying active energy rays to the curable resin layer. The active energy rays may be applied using a high-pressure mercury lamp, an electrodeless lamp, a xenon lamp, or the like.

The wavelength of the active energy rays is preferably 200 to 400 nm, and more preferably 350 to 400 nm. The intensity is normally 50 to 1000 $mW/cm^2$, and the dose is normally 50 to 5000 $mJ/cm^2$ (preferably 1000 to 5000 $mJ/cm^2$). The irradiation time is normally 0.1 to 1000 seconds, preferably 1 to 500 seconds, and more preferably 10 to 100 seconds. The active energy rays may be applied a plurality of times so that the dose falls within the above range taking account of the thermal load during the irradiation step.

In order to prevent a deterioration in the thermoplastic resin (A) or coloration of the cured resin layer due to the active energy rays, the active energy rays may be applied to the curable resin composition through a filter that absorbs light having a wavelength unnecessary for the curing reaction. In this case, since light having a wavelength that is unnecessary for the curing reaction and causes the thermoplastic resin (A) to deteriorate is absorbed by the filter, a deterioration in the thermoplastic resin (A) can be suppressed, and a colorless and transparent cured resin layer can be easily obtained.

A resin film such as a polyethylene terephthalate film may be used as the filter. When using a resin film, it is preferable to provide a step that stacks a resin film such as a polyethylene terephthalate film on the curable resin layer between the step 1 and the step 2. The resin film is normally removed after the step 2.

The curable resin layer may be cured by applying electron beams to the curable resin layer. In this case, the curable resin layer can normally be cured even if a photoinitiator is not used. Electron beams may be applied using an electron beam accelerator or the like. The dose is normally 10 to 1000 krad. The irradiation time is normally 0.1 to 1000 seconds, preferably 1 to 500 seconds, and more preferably 10 to 100 seconds.

Step 3

In the step 3, a gas barrier layer is formed on the cured resin layer obtained by the step 2.

The gas barrier layer may be formed using the above method.

For example, when the gas barrier layer is a layer obtained by implanting ions into a layer that includes a silicon-containing polymer compound, the gas barrier layer may be formed by forming a layer that includes a silicon-containing polymer compound on the cured resin layer, and implanting ions into the layer that includes a silicon-containing polymer compound.

The layer that includes a silicon-containing polymer compound may be formed, and ions may be implanted using the above methods.

It is preferable to produce the gas barrier film by implanting ions into the layer that includes a silicon-containing polymer compound while feeding a long film in which the layer that includes a silicon-containing polymer compound is formed on the cured resin layer obtained by the step 2 in a given direction.

According to this method, it is possible to continuously produce a long gas barrier film.

The process sheet is normally removed in a specific step corresponding to the application of the gas barrier film and the like. For example, an additional layer or the like may be formed after the step 3, and the process sheet may then be removed, or the process sheet may be removed after the step 3. Alternatively, the process sheet may be removed between the step 2 and the step 3.

Although the method that includes the steps 1 to 3 forms the curable resin layer utilizing the process sheet, the gas barrier film obtained by this method may or may not include the process sheet.

The method for producing a gas barrier film according to one embodiment of the invention can efficiently, continuously, and easily produce the gas barrier film according to one embodiment of the invention.

3) Gas barrier film laminate

A gas barrier film laminate according to one embodiment of the invention has a configuration in which two or more gas barrier films according to one embodiment of the invention are stacked through a bonding layer.

Gas barrier film

The gas barrier film included in the gas barrier film laminate according to one embodiment of the invention is not particularly limited as long as the gas barrier film is the gas barrier film according to one embodiment of the invention.

The thickness of the cured resin layer included in the gas barrier film used to produce the gas barrier film laminate is preferably 0.5 to 10 μm, and more preferably 1 to 5 μm. When the thickness of the cured resin layer is within the above range, it is possible to obtain a gas barrier film laminate that exhibits an excellent gas barrier capability, and has a reduced thickness.

Bonding layer

The bonding layer included in the gas barrier film laminate is a layer that bonds the gas barrier films, and maintains the laminate structure of the gas barrier film laminate. The bonding layer may be a single layer, or may include a plurality of layers. The bonding layer may be a layer that is formed using an adhesive, and has a single-layer structure, or may be a layer in which a layer formed using an adhesive is provided on each side of a support layer.

A material for forming the bonding layer is not particularly limited as long as the material can bond the gas barrier films, and maintain the laminate structure of the gas barrier film laminate. A known adhesive may be used as the material for forming the bonding layer. It is preferable to use a pressure-sensitive adhesive since the gas barrier films can be bonded at room temperature.

Examples of the pressure-sensitive adhesive for forming the bonding layer include an acrylic-based pressure-sensitive adhesive, a urethane-based pressure-sensitive adhesive, a silicone-based pressure-sensitive adhesive, a rubber-based pressure-sensitive adhesive, and the like. Among these, it is preferable to use an acrylic-based pressure-sensitive adhesive or a urethane-based pressure-sensitive adhesive from the viewpoint of adhesion, transparency, and handling capability. It is preferable to use a pressure-sensitive adhesive that can form a crosslinked structure (described later).

The pressure-sensitive adhesive may be a solvent-type pressure-sensitive adhesive, an emulsion-type pressure-sensitive adhesive, a hot-melt-type pressure resistive adhesive, or the like.

The acrylic-based pressure-sensitive adhesive is a pressure-sensitive adhesive that includes an acrylic-based copolymer as the main component.

The acrylic-based copolymer is a copolymer that includes a repeating unit derived from (meth)acrylic acid or a (meth)acrylate. Note that the term "(meth)acrylic" refers to "acrylic" or "methacrylic".

The acrylic-based copolymer may include a repeating unit other than the repeating unit derived from (meth)acrylic acid or a (meth)acrylate.

These acrylic-based copolymers may be used either alone or in combination.

It is preferable that the acrylic-based copolymer be a copolymer of an acrylic-based monomer that includes a functional group that can form a crosslinked structure (hereinafter may be referred to as "functional group"), an acrylic-based monomer that does not include a functional group, and an additional monomer that is copolymerizable with these monomers. The acrylic-based monomer that includes a functional group contributes to formation of a crosslinked structure, and the acrylic-based monomer that does not include a functional group contributes to an improvement in adhesion.

Examples of the functional group included in the acrylic-based monomer that includes a functional group include a carboxyl group, a hydroxyl group, an amino group, an amide group, and the like. Note that the functional group is selected depending on the type of crosslinking agent.

It is preferable that the acrylic-based monomer that does not include a functional group include a hydrocarbon group having 4 to 10 carbon atoms since a bonding layer that exhibits excellent adhesion can be formed.

Examples of the acrylic-based monomer that includes a functional group include an acrylic-based monomer that includes a carboxyl group, such as (meth)acrylic acid and 2-carboxyethyl (meth)acrylate; an acrylic-based monomer that includes a hydroxyl group, such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, and 4-hydroxybutyl (meth)acrylate; and the like.

These monomers may be used either alone or in combination.

Examples of the acrylic-based monomer that does not include a functional group include an acrylic-based monomer that includes a linear alkyl group, such as methyl (meth)acrylate, ethyl (meth)acrylate, propyl (meth)acrylate, butyl (meth)acrylate, pentyl (meth)acrylate, hexyl (meth)acrylate, octyl (meth)acrylate, decyl (meth)acrylate, dodecyl (meth)acrylate, myristyl (meth)acrylate, palmityl (meth)acrylate, and stearyl (meth)acrylate; an acrylic-based monomer that includes a branched alkyl group, such as 2-ethylhexyl (meth)acrylate and isooctyl (meth)acrylate; an acrylic-based monomer that includes a cycloalkyl group, such as cyclohexyl (meth)acrylate; and the like.

These monomers may be used either alone or in combination.

Examples of the additional monomer include a monomer that includes a carboxyl group, such as crotonic acid, maleic acid, fumaric acid, itaconic acid, and citraconic acid; a monomer that includes an amide group, such as (meth)acrylamide, N-methyl(meth)acrylamide, and N-methylol(meth)acrylamide; acrylonitrile; styrene; vinyl acetate; vinylpyrrolidone; and the like.

The acrylic-based copolymer may be produced using an arbitrary method. A known method such as a solution polymerization method, an emulsion polymerization method, a suspension polymerization method, or a bulk polymerization method may be used. It is preferable to use a solution polymerization method due to ease of polymerization.

An initiator used for polymerization is not particularly limited. Examples of the initiator include a peroxide-based initiator such as benzoyl peroxide, lauroyl peroxide, and methyl ethyl ketone peroxide, an azo-based initiator such as azobisisobutyronitrile, azobiscyanovarelic acid, and azobiscyanopentane, and the like.

A solvent used for polymerization is not particularly limited. Examples of the solvent include toluene, hexane, heptane, ethyl acetate, acetone, methyl ethyl ketone, methanol, and the like.

Known polymerization conditions (e.g., polymerization temperature and polymerization time) may be employed.

The weight average molecular weight of the acrylic-based copolymer is normally 100,000 to 1,000,000, and preferably 300,000 to 900,000. Note that the weight average molecular weight of the acrylic-based copolymer refers to a polystyrene-reduced weight average molecular weight determined by gel permeation chromatography (GPC).

A crosslinking agent may be added to the acrylic-based pressure-sensitive adhesive. The crosslinking agent is a compound that reacts with the functional group included in the acrylic-based monomer that includes a functional group to effect crosslinking. The cohesive force of the acrylic-based pressure-sensitive adhesive can be improved by utilizing the crosslinking agent. The crosslinking agent is not particularly limited. Examples of the crosslinking agent include an isocyanate-based crosslinking agent, an epoxy-based crosslinking agent, and the like.

The isocyanate-based crosslinking agent is not particularly limited. A compound that includes two or more isocyanate groups in the molecule may be used as the isocyanate-based crosslinking agent. Examples of the isocyanate-based crosslinking agent include aromatic polyisocyanates such as tolylene diisocyanate, diphenylmethane diisocyanate, and xylylene diisocyanate, aliphatic polyisocyanates such as hexamethylenediisocyanate, alicyclic polyisocyanates such as isophorone diisocyanate and hydrogenated diphenylmethane diisocyanate, biuret types, isocyanurate types, and adducts (reaction products with a low-molecular-weight active hydrogen-containing compound (e.g., ethylene glycol, propylene glycol, neopentyl glycol, trimethylolpropane, or castor oil) thereof, and the like.

A compound that includes two or more epoxy groups in the molecule is used as the epoxy-based crosslinking agent. Examples of the epoxy-based crosslinking agent include sorbitol tetraglycidyl ether, trimethylolpropane glycidyl ether, tetraglycidyl-1,3-bisaminomethylcyclohexane, tetraglycidyl-m-xylenediamine, triglycidyl-p-aminophenol, and the like.

These crosslinking agents may be used either alone or in combination.

The crosslinking agent is normally used in an amount of 0.01 to 10 parts by mass, and preferably 0.05 to 5

parts by mass, based on 100 parts by mass of the acrylic-based copolymer.

The urethane-based pressure-sensitive adhesive is a pressure-sensitive adhesive that includes a urethane-based resin as the main component (including a case where the pressure-sensitive adhesive includes only the urethane-based resin). A urethane-based adhesive falls under the urethane-based pressure-sensitive adhesive.

The urethane-based pressure-sensitive adhesive is not particularly limited as long as the urethane-based pressure-sensitive adhesive can form a pressure-sensitive adhesive layer that has the desired characteristics. A known urethane-based pressure-sensitive adhesive may be used.

Examples of the urethane-based resin include a polyether polyurethane, a polyester polyurethane, and the like.

These urethane-based resins may be used either alone or in combination.

The urethane-based resin may have a three-dimensional crosslinked structure obtained by reacting a urethane prepolymer having a terminal isocyanate group with a crosslinking agent (e.g., triol or diamine).

The pressure-sensitive adhesive used for the bonding layer may include an additive as long as adhesion and the like are not impaired. Examples of the additive include a light stabilizer, an antioxidant, a tackifier, a plasticizer, a UV absorber, a coloring agent, a resin stabilizer, a filler, a pigment, an extender, an antistatic agent, a silane coupling agent, and the like. These additives may be used either alone or in combination.

The bonding layer may be formed using an arbitrary method. For example, when the pressure-sensitive adhesive used for the bonding layer is a solvent-type pressure-sensitive adhesive or an emulsion-type pressure-sensitive adhesive, the pressure-sensitive adhesive may be applied using a known coating method (e.g., spin coating method, spray coating method, bar coating method, knife coating method, roll coating method, blade coating method, die coating method, or gravure coating method), and the solvent may be removed from the resulting film by drying, followed by optional heating to form a bonding layer.

When the pressure-sensitive adhesive used for the bonding layer is a hot-melt-type pressure resistive adhesive, the pressure-sensitive adhesive may be applied using a hot-melt method utilizing a phenomenon in which the pressure-sensitive adhesive is easily melted due to heating to exhibit fluidity. The hot-melt-type pressure resistive adhesive that has been melted may be applied using a known coating method using a T-die, a fountain die, a gear-in die, a slot die, or the like, and cooled to form a bonding layer.

The thickness of the bonding layer is not particularly limited. The thickness of the bonding layer is preferably 0.5 to 100 μm, more preferably 1 to 60 μm, and still more preferably 3 to 40 μm. When the thickness of the bonding layer is 0.5 μm or more, good adhesion can be obtained. When the thickness of the bonding layer is 100 μm or less, productivity can be improved.

3) Gas barrier film laminate

FIG. 2 ((a) to (c)), FIG. 3 ((a) and (b)), FIG. 4 ((a) and (b)), and FIG. 5 ((a) to (c)) illustrate examples of the gas barrier film laminate according to one embodiment of the invention. Note that the gas barrier film laminate according to one embodiment of the invention is not limited to those illustrated in FIGS. 2 to 5. The following description illustrates the layer configuration of the gas barrier film laminate, and does not limit the order of the production steps (order of stacking).

A gas barrier film laminate (30) illustrated in FIG. 2 (see (a)) has a layer configuration (cured resin layer (1a)/gas barrier layer (2a)/bonding layer (3)/gas barrier layer (2b)/cured resin layer (1b)) in which a gas barrier film (10a) and a gas barrier film (10b) are stacked so that a gas barrier layer (2a) of the gas barrier film (10a) and a gas barrier layer (2b) of the gas barrier film (10b) face each other through a bonding layer (3).

A gas barrier film laminate (40) illustrated in FIG. 2 (see (b)) has a layer configuration (gas barrier layer (2a)/cured resin layer (1a)/bonding layer (3)/cured resin layer (1b)/gas barrier layer (2b)) in which a gas barrier film (10a) and a gas barrier film (10b) are stacked so that a cured resin layer (1a) of the gas barrier film (10a) and a cured resin layer (1b) of the gas barrier film (10b) face each other through a bonding layer (3).

A gas barrier film laminate (50) illustrated in FIG. 2 (see (c)) has a layer configuration (cured resin layer (1a)/gas barrier layer (2a)/bonding layer (3)/cured resin layer (1b)/gas barrier layer (2b)) in which a gas barrier film (10a) and a gas barrier film (10b) are stacked so that a gas barrier layer (2a) of the gas barrier film (10a) and a cured resin layer (1b) of the gas barrier film (10b) face each other through a bonding layer (3).

A gas barrier film laminate (60) illustrated in FIG. 3 (see (a)) has a layer configuration (cured resin layer (1a)/gas barrier layer (2a)/bonding layer (3a)/cured resin layer (1b)/gas barrier layer (2b)/bonding layer (3b)/gas barrier layer (2c)/cured resin layer (1c)) in which a gas barrier film (10a), a gas barrier film (10b), and a gas barrier film (10c) are stacked so that a gas barrier layer (2a) of the gas barrier film (10a) and a cured resin layer (1b) of the gas barrier film (10b) face each other through a bonding layer (3a), and a gas barrier layer (2b) of the gas barrier film (10b) and a gas barrier layer (2c) of the gas barrier film (10c) face each other through a bonding layer (3b).

A gas barrier film laminate (70) illustrated in FIG. 3 (see (b)) includes a gas barrier film (10a), a gas barrier film (10b), and a gas barrier film (10c) in the same manner as the gas barrier film laminate (60), and has a layer configuration

(cured resin layer (1a)/gas barrier layer (2a)/bonding layer (3a)/cured resin layer (1b)/gas barrier layer (2b)/bonding layer (3b)/cured resin layer (1c)/gas barrier layer (2c)).

A gas barrier film laminate (80) illustrated in FIG. 4 (see (a)) has a layer configuration (cured resin layer (1a)/gas barrier layer (2a)/bonding layer (3a)/gas barrier layer (2b)/cured resin layer (1b)/bonding layer (3b)/cured resin layer (1c)/gas barrier layer (2c)/bonding layer (3c)/gas barrier layer (2d)/cured resin layer (1d)) in which a gas barrier film laminate (30a) and a gas barrier film laminate (30b) are stacked so that a cured resin layer (1b) of the gas barrier film laminate (30a) and a cured resin layer (1c) of the gas barrier film laminate (30b) face each other through a bonding layer (3b).

A gas barrier film laminate (90) illustrated in FIG. 4 (see (b)), a gas barrier film laminate (100) illustrated in FIG. 5 (see (a)), a gas barrier film laminate (110) illustrated in FIG. 5 (see (b)), and a gas barrier film laminate (120) illustrated in FIG. 5 (see (c)) include two gas barrier film laminates in the same manner as the gas barrier film laminate (80), and respectively have the following layer configurations.

Gas barrier film laminate (90): (gas barrier layer (2a)/cured resin layer (1a)/bonding layer (3a)/cured resin layer (1b)/gas barrier layer (2b)/bonding layer (3 b)/gas barrier layer (2c)/cured resin layer (1c)/bonding layer (3c)/cured resin layer (1d)/gas barrier layer (2d))

Gas barrier film laminate (100): (gas barrier layer (2a)/cured resin layer (1a)/bonding layer (3a)/cured resin layer (1b)/gas barrier layer (2b)/bonding layer (3b)/cured resin layer (1c)/gas barrier layer (2c)/bonding layer (3c)/cured resin layer (1d)/gas barrier layer (2d))

Gas barrier film laminate (110): (cured resin layer (1a)/gas barrier layer (2a)/bonding layer (3a)/cured resin layer (1b)/gas barrier layer (2b)/bonding layer (3b)/cured resin layer (1c)/gas barrier layer (2c)/bonding layer (3c)/cured resin layer (1d)/gas barrier layer (2d))

Gas barrier film laminate (120): (gas barrier layer (2a)/cured resin layer (1a)/bonding layer (3a)/cured resin layer (1b)/gas barrier layer (2b)/bonding layer (3b)/cured resin layer (1c)/gas barrier layer (2c)/bonding layer (3c)/gas barrier layer (2d)/cured resin layer (1d))

Among these, the gas barrier film laminates (30), (60), and (80) in which the gas barrier layer is not exposed on the outermost surface are preferable since the gas barrier layer is rarely damaged, and a deterioration in gas barrier capability rarely occurs.

The gas barrier film laminates (30), (40), (80), and (90) that are configured so that the gas barrier layers or the cured resin layers face each other are also preferable since curling of the laminate can be suppressed due to a symmetrical laminate structure.

The gas barrier film laminate according to one embodiment of the invention has a configuration in which two or more gas barrier films according to one embodiment of the invention are bonded. Therefore, the gas barrier film laminate according to one embodiment of the invention exhibits an excellent gas barrier capability in addition to the excellent characteristics (e.g., low birefringence, excellent optical isotropy, excellent heat resistance, excellent solvent resistance, and excellent interlayer adhesion) of the cured resin layer.

The gas barrier film laminate according to one embodiment of the invention is not limited to those illustrated in FIGS. 2 to 5. The gas barrier film laminate according to one embodiment of the invention may further include one additional layer, or two or more additional layers as long as the object of the invention is not impaired.

When the gas barrier film laminate according to one embodiment of the invention includes an additional layer, the position of the additional layer is not particularly limited.

Examples of the additional layer include a conductive layer, an impact-absorbing layer, an adhesive layer, a bonding layer, a process sheet, and the like (see above).

The gas barrier film laminate according to one embodiment of the invention may be produced by bonding two or more gas barrier films according to one embodiment of the invention through the bonding layer.

For example, the gas barrier film laminate (30) illustrated in FIG. 2 (see (a)) may be produced by the following method.

Two gas barrier films (10) illustrated in FIG. 6 (see (a)) are provided (hereinafter referred to as "gas barrier film (10a)" and "gas barrier film (10b)"), the gas barrier film (10a) and the gas barrier film (10b) respectively including a cured resin layer (1), and a gas barrier layer (2) that is provided on the cured resin layer (1).

A bonding layer (3) is formed on a release sheet (4) to obtain a release sheet (130) provided with the bonding layer (see (b) in FIG. 6). The release sheet (130) may include an additional release sheet provided on the bonding layer (3). The release sheet (4) is not particularly limited. A release sheet described above in connection with the process sheet, and exhibits excellent removability from the bonding layer may be appropriately selected.

The gas barrier layer (2a) of the gas barrier film (10a) and the bonding layer (3) of the release sheet (130) are bonded with optional heating to obtain a gas barrier film (140) provided with the bonding layer (see (c) in FIG. 6). The gas barrier layer (2a) and the bonding layer (3) may be bonded using an arbitrary method. For example, the gas barrier

layer (2a) and the bonding layer (3) may be bonded using a known laminator.

The release sheet (4) of the gas barrier film (140) is removed, and the gas barrier layer (2b) of the gas barrier film (10b) is bonded to the exposed bonding layer (3) with optional heating (see (d) in FIG. 6) to obtain a gas barrier film laminate (30) (see (e) in FIG. 6).

The gas barrier film laminate according to one embodiment of the invention may be produced by another method.

For example, a bonding layer may be formed directly on the gas barrier layer (2) of the gas barrier film (10) (see (a) in FIG. 6), and another gas barrier film may be bonded to the bonding layer with optional heating to obtain a gas barrier film laminate.

When bonding four or more gas barrier films, the gas barrier film may be bonded one by one, or the resulting gas barrier film laminates may be bonded to each other.

For example, when producing the gas barrier film laminate (80) illustrated in FIG. 4 (see (a)), the gas barrier film may be bonded one by one, or the gas barrier film laminate (30b) and the gas barrier film laminate (30a) may be bonded to each other.

4) Electronic device member and electronic device

An electronic device member according to one embodiment of the invention includes the gas barrier film according to one embodiment of the invention or the gas barrier film laminate according to one embodiment of the invention. Therefore, since the electronic device member according to one embodiment of the invention exhibits excellent heat resistance, excellent solvent resistance, excellent interlayer adhesion, and an excellent gas barrier capability, has a low birefringence, and exhibits excellent optical isotropy, the electronic device member may suitably be used as a display member for touch panels, liquid crystal displays, EL displays, and the like; a back side protective sheet for solar cells; and the like.

An electronic device according to one embodiment of the invention includes the electronic device member according to one embodiment of the invention. Specific examples of the electronic device include a touch panel, a liquid crystal display, an organic EL display, an inorganic EL display, electronic paper, a solar cell, and the like.

EXAMPLES

The invention is further described below by way of examples. Note that the invention is not limited to the following examples.

In the following examples, the unit "parts" refers to "parts by mass" unless otherwise indicated.

Preparation of curable resin composition

Production Example 1: Preparation of curable resin composition 1

60 parts of pellets of a polysulfone-based resin (PSF) ("ULTRASON S3010" manufactured by BASF, Tg: 180°C) (thermoplastic resin (A)) were dissolved in dichloromethane to prepare a 15 mass% PSF solution. After the addition of 40 parts of tricyclodecanedimethanol diacrylate ("ADCP" manufactured by Shin-Nakamura Chemical Co., Ltd.) (curable monomer (B)) and 1 part of bis(2,4,6-trimethylbenzoyl)phenylphosphine oxide ("Irgacure 819" manufactured by BASF) (initiator) to the solution, the components were mixed to prepare a curable resin composition 1.

Production Examples 2 to 5: Preparation of curable resin compositions 2 to 5

Curable resin compositions 2 to 5 were prepared in the same manner as in Production Example 1, except that the components were used in the amounts shown in Table 1.

Production Example 6: Preparation of curable resin composition 6

40 parts of pellets of a cycloolefin copolymer (COC) ("ARTON F5023" manufactured by JSR Corporation, Tg: 165°C) (thermoplastic resin (A)) were dissolved in dichloromethane to prepare a 15 mass% COC solution. After the addition of 60 parts of tricyclodecanedimethanol diacrylate ("ADCP" manufactured by Shin-Nakamura Chemical Co., Ltd.) (curable monomer (B)) and 1 part of bis(2,4,6-trimethylbenzoyl)phenylphosphine oxide ("Irgacure 819" manufactured by BASF) (initiator) to the solution, the components were mixed to prepare a curable resin composition 6.

Production Example 7: Preparation of curable resin composition 7

60 parts of pellets of a polysulfone-based resin (PSF) ("ULTRASON S3010" manufactured by BASF, Tg: 180°C) (thermoplastic resin (A)) were dissolved in dichloromethane to prepare a 15 mass% PSF solution. After the addition of 40 parts of ethoxylated bisphenol A diacrylate ("ABE300" manufactured by Shin-Nakamura Chemical Co., Ltd.) (curable monomer (B)) and 1 part of bis(2,4,6-trimethylbenzoyl)phenylphosphine oxide ("Irgacure 819" manufactured by BASF) (initiator) to the solution, the components were mixed to prepare a curable resin composition 7.

Production Example 8: Preparation of curable resin composition 8

60 parts of pellets of a polysulfone-based resin (PSF) ("ULTRASON S3010" manufactured by BASF, Tg: 180°C) (thermoplastic resin (A)) were dissolved in dichloromethane to prepare a 15 mass% PSF solution. After the addition of 40 parts of 9,9-bis[4-(2-acryloyloxyethoxy)phenyl]fluorene ("ABPEF" manufactured by Shin-Nakamura Chemical Co., Ltd.) (curable monomer (B)) and 1 part of bis(2,4,6-trimethylbenzoyl)phenylphosphine oxide ("Irgacure 819" manufactured by BASF) (initiator) to the solution, the components were mixed to prepare a curable resin composition 8.

Production Example 9: Production of release sheet provided with bonding layer

100 parts of an acrylic-based copolymer obtained using butyl acrylate (BA) and acrylic acid (AA) (mass ratio (BA:AA)=90:10, weight average molecular weight: 550,000) and 0.22 parts of an isocyanate-based crosslinking agent ("BHS-8515" manufactured by Toyo Ink Mfg. Co., Ltd., concentration: 37.5 mass%) were mixed. The mixture was diluted with methyl ethyl ketone to prepare a pressure-sensitive adhesive having a nonvolatile content of 30 mass%.

The pressure-sensitive adhesive was applied to the surface of the release layer of a release sheet in which a silicone release layer is provided on one side of a polyethylene terephthalate film having a thickness of 38 μm ("SP-PET381031" manufactured by Lintec Corporation) using a comma direct coating method, and the resulting film was dried at 100°C for 1 minute to form a bonding layer having a thickness of about 10 μm. A release sheet provided with a bonding layer was thus obtained.

Example 1

The curable resin composition 1 obtained in Production Example 1 was applied to one side (i.e., the side opposite to the easily adhering side (layer)) of a polyethylene terephthalate (PET) film ("TET50A-4100" manufactured by Toyobo Co., Ltd., thickness: 50 μm, surface roughness Ra: 1.0 nm, surface roughness Rt: 16nm) (process sheet) using a fountain die method so that the thickness after drying was 50 μm. The resulting film was heated at 50°C for 2 minutes, and then heated at 140°C for 2 minutes to dry the film.

A PET film ("PET50A-4100" manufactured by Toyobo Co., Ltd., thickness: 50 μm) was stacked on the dry film. Ultraviolet rays were applied to the dry film through the process sheet using a belt conveyer-type UV irradiation device ("ECS-401GX" manufactured by Eye Graphics Co., Ltd.) and a high-pressure mercury lamp ("H04-L41" manufactured by Eye Graphics Co., Ltd.) (height of UV lamp: 150 mm, output of UV lamp: 3 kw (120mW/cm), wavelength: 365 nm, intensity: 271 $mW/cm^2$, dose: 177 $mJ/cm^2$ (UV meter: "UV-351" manufactured by ORC Manufacturing Co., Ltd.). Next, ultraviolet rays were applied twice using the UV irradiation device (height of UV lamp: 150 mm, wavelength: 365 nm, intensity: 271 $mW/cm^2$, dose: 600 $mJ/cm^2$) (total dose: 1377 $mJ/cm^2$) to effect a curing reaction to form a cured resin layer 1.

After removing the PET film, a coating material including perhydropolysilazane (silicon-containing polymer) as the main component ("Aquamika NL110-20" manufactured by Clariant Japan K.K.) was spin-coated onto the cured resin layer 1 so that the thickness after drying was 150 nm, and heated at 120°C for 2 minutes to form a polymer resin layer.

Argon (Ar) ions were implanted into the surface of the polymer resin layer under the following plasma ion implantation conditions using a plasma ion implantation apparatus to form a gas barrier layer.

The PET film used as the process sheet was removed to obtain a gas barrier film 1.

Plasma ion implantation conditions

Gas flow rate: 100 sccm
Duty ratio: 0.5%
Repetition frequency: 1000 Hz
Applied voltage: -10 kV

RF power supply: frequency: 13.56 MHz, applied electric power: 1000 W
Chamber internal pressure: 0.2 Pa
Pulse width: 5 μs
Processing time (ion implantation time): 5 min
Feeding speed: 0.2 m/min

Examples 2 to 5

Cured resin layers 2 to 5 were respectively formed in the same manner as in Example 1, except that the curable resin compositions 2 to 5 were respectively used instead of the curable resin composition 1. A gas barrier layer was respectively formed on the cured resin layers 2 to 5 in the same manner as in Example 1 to obtain gas barrier films 2 to 5.

Example 6

A cured resin layer 5 was formed in the same manner as in Example 5 using the curable resin composition 5. A silicon nitride gas barrier layer having a thickness of 60 nm was formed on the cured resin layer 5 using a sputtering method to obtain a gas barrier film 6.

Example 7

A cured resin layer 6 was formed in the same manner as in Example 1, except that the curable resin composition 6 was used instead of the curable resin composition 1. A gas barrier layer was formed on the cured resin layer 6 in the same manner as in Example 1 to obtain a gas barrier film 7.

Examples 8 and 9

Cured resin layers 7 and 8 were respectively formed in the same manner as in Example 1, except that the curable resin compositions 7 and 8 were respectively used instead of the curable resin composition 1. A gas barrier layer was respectively formed on the cured resin layers 7 and 8 in the same manner as in Example 1 to obtain gas barrier films 8 and 9.

Comparative Example 1

A gas barrier film 10 was obtained in the same manner as in Example 1, except that a PET film ("PET50A-4100" manufactured by Toyobo Co., Ltd., thickness: 50 μm, Tg: 90°C) was used instead of the cured resin layer 1, and a gas barrier layer was formed on the side of the PET film opposite to the easily adhering side.

Comparative Example 2

A gas barrier film 11 was obtained in the same manner as in Example 6, except that a PET film ("PET50A-4100" manufactured by Toyobo Co., Ltd., thickness: 50 μm, Tg: 90°C) was used instead of the cured resin layer 5, and a gas barrier layer was formed on one side (i.e., the side opposite to the easily adhering side (layer)) of the PET film.

Comparative Example 3

Polycarbonate (PC) pellets ("Tarflon LC1700" manufactured by Idemitsu Kosan Co., Ltd., Tg: 145°C) were dissolved in dichloromethane to prepare a 10 mass% PC solution. The solution was applied to one side (i.e., the side opposite to the easily adhering side (layer)) of a PET film ("PET50A-4100" manufactured by Toyobo Co., Ltd., thickness: 50 μm) using a fountain die method so that the thickness after drying was 50 μm. The resulting film was dried at 60°C for 8 hours, and then dried at 130°C for 3 hours. The PET film was then removed to obtain a PC film having a thickness of 50 μm.

A gas barrier layer was formed in the same manner as in Example 1, except that the PC film was used instead of the cured resin layer 1, to obtain a gas barrier film 12.

Comparative Example 4

A gas barrier layer was formed in the same manner as in Example 6, except that the PC film obtained in Comparative Example 3 was used instead of the cured resin layer 1, to obtain a gas barrier film 13.

Comparative Example 5

Pellets of a cycloolefin copolymer (COC) ("TOPAS 6017" manufactured by Polyplastics Co., Ltd., Tg: 180°C) were dissolved in dichloromethane to prepare a 10 mass% COC solution. The solution was applied to one side (i.e., the side opposite to the easily adhering side (layer)) of a PET film ("PET50A-4100" manufactured by Toyobo Co., Ltd., thickness: 50 μm) (process sheet) using a fountain die method so that the thickness after drying was 50 μm. The resulting film was dried at 60°C for 8 hours, and then dried at 130°C for 3 hours. The PET film used as the process sheet was removed to obtain a COC film having a thickness of 50 μm.

A gas barrier layer was formed in the same manner as in Example 1, except that the COC film was used instead of the cured resin layer 1, to obtain a gas barrier film 14.

Comparative Example 6

A gas barrier layer was formed in the same manner as in Example 6, except that the COC film obtained in Comparative Example 5 was used instead of the cured resin layer 5, to obtain a gas barrier film 15.

Comparative Example 7

Pellets of a polysulfone-based resin (PSF) ("ULTRASONS 3010" manufactured by BASF, Tg: 180°C) were dissolved in dichloromethane to prepare a 10 mass% PSF solution. The solution was applied to one side (i.e., the side opposite to the easily adhering side (layer)) of a PET film ("PET50A-4100" manufactured by Toyobo Co., Ltd., thickness: 50 μm) (process sheet) using a fountain die method so that the thickness after drying was 50 μm). The resulting film was dried at 60°C for 8 hours, and then dried at 130°C for 3 hours. The PET film used as the process sheet was removed to obtain a PSF film having a thickness of 50 μm.

A gas barrier layer was formed in the same manner as in Example 1, except that the PSF film was used instead of the cured resin layer 1, to obtain a gas barrier film 16.

Comparative Example 8

A gas barrier layer was formed in the same manner as in Example 6, except that the PSF film obtained in Comparative Example 7 was used instead of the cured resin layer 5, to obtain a gas barrier film 17.

Measurement of glass transition temperature (Tg) of cured resin layer

The cured resin layers 1 to 8 used in Examples 1 to 9 were subjected to viscoelasticity measurement (frequency: 11 Hz, temperature increase rate 3°C/min, temperature range: 0 to 250°C, measured in tensile mode) using a viscoelasticity measurement device ("DMA Q800" manufactured by TA Instruments Japan Inc.), and the temperature corresponding to the maximum tanδ value (loss modulus/storage modulus) obtained by the viscoelasticity measurement was taken as the glass transition temperature (Tg). The measurement results are shown in Table 1.

The glass transition temperature (Tg) of the films used in Comparative Examples 1 to 8 was also measured in the same manner as described above. The measurement results are shown in Table 2.

Solvent resistance evaluation test using cured resin layer

The cured resin layers 1 to 8 used in Examples 1 to 9 were cut to have dimensions of 100×100 mm to obtain measurement samples.

The measurement sample was wrapped with a nylon mesh (#120) (150×150 mm of which the mass had been measured in advance), immersed in toluene (100 mL) for 3 days, removed, and dried at 120°C for 1 hour. After allowing the measurement sample to stand at a temperature of 23°C and a relative humidity of 50% for 3 hours, the mass of the measurement sample was measured, and the gel fraction was calculated by the following expression. The results are shown in Table 1.

$$\text{Gel fraction (\%)} = [(\text{weight of residual resin after immersion}) / (\text{weight of resin before immersion})] \times 100$$

The solvent resistance of the cured resin layer was evaluated as "Acceptable" when the gel fraction was 90%

or more, and evaluated as "Unacceptable" when the gel fraction was less than 90%.

The gel fraction of the films used in Comparative Examples 1 to 8 was also measured in the same manner as described above to evaluate the solvent resistance. The evaluation results are shown in Table 2.

Measurement of birefringence of cured resin layer

The birefringence of the cured resin layers 1 to 8 used in Examples 1 to 9 was measured at 23°C using a retardation measurement device ("KOBRA-WR" manufactured by Oji Scientific Instruments, wavelength: 589 nm). The measurement results are shown in Table 1.

The birefringence of the films used in Comparative Examples 1 to 8 was also measured in the same manner as described above. The measurement results are shown in Table 2.

Interlayer adhesion evaluation test using gas barrier film

The gas barrier films 1 to 17 obtained in Examples 1 to 9 and Comparative Examples 1 to 8 were allowed to stand at a temperature of 60°C and a humidity of 90% for 150 hours, and subjected to a cross-cut adhesion test (JIS K-5400 (1990)) to evaluate the interlayer adhesion between the gas barrier layer and the cured resin layer (or the base film). The evaluation results are shown in Tables 3 and 4.

A case where 90 squares or more among 100 squares remained after the cross-cut adhesion test was evaluated as "Acceptable", and a case where less than 90 squares among 100 squares remained after the cross-cut adhesion test was evaluated as "Unacceptable".

Measurement of water vapor transmission rate of gas barrier film

The gas barrier films 1 to 9 obtained in Examples 1 to 9 were cut to have dimensions of 233×309 mm using a cutting machine ("Super Cutter PN1-600" manufactured by Ogino Seiki Co., Ltd.) to obtain measurement samples. The gas barrier films 10 to 17 obtained in Comparative Examples 1 to 8 were also cut in the same manner as described above to obtain measurement samples.

The water vapor transmission rate of the measurement sample was measured using a water vapor transmission rate measurement device ("L89-5000" manufactured by LYSSY) at a temperature of 40°C and a relative humidity of 90%. The measurement results are shown in Tables 3 and 4.

Evaluation of optical isotropy of gas barrier film

The optical isotropy of the gas barrier films 1 to 9 obtained in Examples 1 to 9 and the gas barrier films 10 to 17 obtained in Comparative Examples 1 to 8 was evaluated based on the birefringence of the cured resin layer or the film.

The optical isotropy of the gas barrier film was evaluated as "Acceptable" when the birefringence of the cured resin layer or the film was less than $20\times10^{-5}$, and evaluated as "Unacceptable" when the birefringence of the cured resin layer or the film was $20\times10^{-5}$ or more. The evaluation results are shown in Tables 3 and 4.

Heat resistance evaluation test using gas barrier film

The gas barrier films 1 to 9 obtained in Examples 1 to 9 and the gas barrier films 10 to 17 obtained in Comparative Examples 1 to 8 were cut to have a width of 4.5 mm to obtain measurement samples.

The measurement sample was secured on a thermomechanical analyzer ("TMA 4000S" manufactured by Mac Science) so that the chuck-to-chuck distance was 15 mm. The atmospheric temperature was increased from 23°C to 150°C at a temperature increase rate of 5°C/min while applying a constant load of -2 gf (i.e., a load of 2 gf in the tensile direction), and the measurement sample was held at 150°C for 30 minutes. The ratio (shrinkage ratio) of the amount of shrinkage with respect to the original length (15 mm) was calculated. The heat resistance was evaluated as "Acceptable" when the shrinkage ratio was less than 0.5%, and evaluated as "Unacceptable" when the shrinkage ratio was more than 0.5%. The evaluation results are shown in Tables 3 and 4.

TABLE 1

| | | | Cured resin layer | | | | | | | |
|---|---|---|---|---|---|---|---|---|---|---|
| | | | 1 | 2 | 3 | 4 | 5 | 6 | 7 | 8 |
| Curable resin composition | Production Example | | 1 | 2 | 3 | 4 | 5 | 6 | 7 | 8 |
| | Thermoplastic resin (A) (parts) | PSF | 60 | 55 | 50 | 45 | 40 | - | 60 | 60 |
| | | COC | - | - | - | - | - | 40 | - | - |
| | Curable monomer (B) (parts) | ADCP | 40 | 45 | 50 | 55 | 60 | 60 | - | - |
| | | ABE300 | - | - | - | - | - | - | 40 | - |
| | | ABPEF | - | - | - | - | - | - | - | 40 |
| | Initiator (parts) | | 1 | 1 | 1 | 1 | 1 | 1 | 1 | 1 |
| Thickness (μm) | | | 50 | 50 | 50 | 50 | 50 | 50 | 50 | 50 |
| Characteristics | Glass transition temperature (Tg) (°C) | | 170 | 170 | 170 | 170 | 170 | 150 | 170 | 170 |
| | Solvent resistance | Gel fraction (%) | 95 | 95 | 95 | 95 | 95 | 95 | 95 | 95 |
| | | Evaluation | Acceptable | Acceptable | Acceptable | Acceptable | Acceptable | Acceptable | Acceptable | Acceptable |
| | Birefringence ($\times 10^{-5}$) | | 2 | 3 | 2 | 5 | 4 | 2 | 2 | 2 |

TABLE 2

<table>
<tr><td colspan="3" rowspan="2"></td><td colspan="4">Film</td></tr>
<tr><td>PET</td><td>PC</td><td>COC</td><td>PSF</td></tr>
<tr><td colspan="3">Thickness (μm)</td><td>50</td><td>50</td><td>50</td><td>50</td></tr>
<tr><td rowspan="4">Characteristics</td><td colspan="2">Glass transition temperature (Tg) (°C)</td><td>90</td><td>145</td><td>180</td><td>180</td></tr>
<tr><td rowspan="2">Solvent resistance</td><td>Gel fraction (%)</td><td>100</td><td>85</td><td>80</td><td>85</td></tr>
<tr><td>Evaluation</td><td>Acceptable</td><td>Unacceptable</td><td>Unacceptable</td><td>Unacceptable</td></tr>
<tr><td colspan="2">Birefringence ($\times 10^{-5}$)</td><td>3200</td><td>20</td><td>3</td><td>18</td></tr>
</table>

TABLE 3

| | | Example | | | | | | | | |
|---|---|---|---|---|---|---|---|---|---|---|
| | | 1 | 2 | 3 | 4 | 5 | 6 | 7 | 8 | 9 |
| Gas barrier film | No. | 1 | 2 | 3 | 4 | 5 | 6 | 7 | 8 | 9 |
| | Cured resin layer | 1 | 2 | 3 | 4 | 5 | 5 | 6 | 7 | 8 |
| | Gas barrier layer | PHPS | PHPS | PHPS | PHPS | PHPS | SiN | PHPS | PHPS | PHPS |
| Interlayer adhesion | Cross-cut adhesion test (number of squares peeled) | 0/100 | 0/100 | 0/100 | 0/1 00 | 0/100 | 0/100 | 0/100 | 0/100 | 0/100 |
| | Evaluation | Acceptable | Acceptable | Acceptable | Acceptable | Acceptable | Acceptable | Acceptable | Acceptable | Acceptable |
| Water vapor transmission rate ($g/m^2/day$) | | 0.02 | 0.02 | 0.02 | 0.02 | 0.02 | 0.4 | 0.02 | 0.02 | 0.02 |
| Optical isotropy | | Acceptable | Acceptable | Acceptable | Acceptable | Acceptable | Acceptable | Acceptable | Acceptable | Acceptable |
| Heat resistance | | Acceptable | Acceptable | Acceptable | Acceptable | Acceptable | Acceptable | Acceptable | Acceptable | Acceptable |

TABLE 4

| | | Comparative Example | | | | | | | |
|---|---|---|---|---|---|---|---|---|---|
| | | 1 | 2 | 3 | 4 | 5 | 6 | 7 | 8 |
| Gas barrier film | No. | 10 | 11 | 12 | 13 | 14 | 15 | 16 | 17 |
| | Film | PET | PET | PC | PC | COC | COC | PSF | PSF |
| | Gas barrier layer | PHPS | SiN | PHPS | SiN | PHPS | SiN | PHPS | SiN |
| Interlayer adhesion | Cross-cut adhesion test (number of squares peeled) | 50/100 | 0/100 | 0/100 | 0/100 | 0/100 | 0/100 | 0/100 | 0/100 |
| | Evaluation | Unacceptable | Acceptable | Acceptable | Acceptable | Acceptable | Acceptable | Acceptable | Acceptable |
| Water vapor transmission rate ($g/m^2/day$) | | 0.02 | 0.4 | 0.04 | 0.4 | 0.04 | 0.4 | 0.04 | 0.4 |
| Optical isotropy | | Unacceptable | Unacceptable | Unacceptable | Unacceptable | Acceptable | Acceptable | Acceptable | Acceptable |
| Heat resistance | | Unacceptable | Unacceptable | Acceptable | Acceptable | Acceptable | Acceptable | Acceptable | Acceptable |

The results shown in Tables 1 to 4 suggest the following.

The cured resin layers 1 to 8 included in the gas barrier films 1 to 9 of Examples 1 to 9 had a high glass transition temperature (Tg), a low birefringence, and a high gel fraction. Therefore, the gas barrier films 1 to 9 produced using the cured resin layers 1 to 8 exhibited excellent heat resistance, excellent solvent resistance, and excellent optical isotropy.

The gas barrier films 1 to 9 also exhibited excellent interlayer adhesion between the gas barrier layer and the cured resin layer, and exhibited an excellent gas barrier capability.

The PET film used in Comparative Examples 1 and 2 had a high gel fraction and exhibited excellent solvent resistance, but had a low glass transition temperature (Tg) (i.e., exhibited poor heat resistance) and a high birefringence. Therefore, the gas barrier films 10 and 11 obtained in Comparative Examples 1 and 2 exhibited poor heat resistance and poor optical isotropy. The gas barrier film 10 obtained in Comparative Example 1 also exhibited poor interlayer adhesion between the gas barrier layer and the cured resin layer.

The PC film, the COC film, and the PSF film used in Comparative Examples 3 to 8 had a high glass transition temperature (Tg) (i.e., exhibited excellent heat resistance), but exhibited poor solvent resistance. The PC film and the PSF film had a high birefringence (i.e., exhibited insufficient birefringent properties).

The comparison between Examples 1 to 9 and Comparative Examples 1 to 8 demonstrate the effects achieved by utilizing the curable monomer (B). Specifically, it was confirmed that a gas barrier film that exhibits excellent heat resistance, excellent solvent resistance, excellent interlayer adhesion, and an excellent gas barrier capability, and has a low birefringence can be obtained by utilizing the curable monomer (B).

Examples 10 to 16

Cured resin layers 9 to 14 were respectively formed in the same manner as in Examples 1 to 7, except that the thickness of the cured resin layer after drying was changed to 10 μm, and a gas barrier layer was respectively formed on the cured resin layers 9 to 14 to obtain gas barrier films 18 to 24.

The details of the cured resin layers 9 to 14 and the gas barrier films 18 to 24 are respectively shown in Tables 5 and 6.

TABLE 5

| | | | Cured resin layer | | | | | |
|---|---|---|---|---|---|---|---|---|
| | | | 9 | 10 | 11 | 12 | 13 | 14 |
| Curable resin composition | Production Example | | 1 | 2 | 3 | 4 | 5 | 6 |
| | Thermoplastic resin (A) (parts) | PSF | 60 | 55 | 50 | 45 | 40 | - |
| | | COC | - | - | - | - | - | 40 |
| | Curable monomer (B) (parts) | ADCP | 40 | 45 | 50 | 55 | 60 | 60 |
| | Initiator (parts) | | 1 | 1 | 1 | 1 | 1 | 1 |
| Thickness (μm) | | | 10 | 10 | 10 | 10 | 10 | 10 |

TABLE 6

| | | Example | | | | | | |
|---|---|---|---|---|---|---|---|---|
| | | 10 | 11 | 12 | 13 | 14 | 15 | 16 |
| Gas barrier film | No. | 18 | 19 | 20 | 21 | 22 | 23 | 24 |
| | Cured resin layer | 9 | 10 | 11 | 12 | 13 | 13 | 14 |
| | Gas barrier layer | PHPS | PHPS | PHPS | PHPS | PHPS | SiN | PHPS |
| Water vapor transmission rate ($g/m^2/day$) | | 0.02 | 0.02 | 0.02 | 0.02 | 0.02 | 0.4 | 0.02 |

Example 17

Two gas barrier films 18 (see Example 10) (in which the process sheet (PET film) was not removed from the cured resin layer) were provided. The gas barrier layer of one of the two gas barrier films 18 was bonded to the bonding

layer of the release sheet provided with a bonding layer obtained in Production Example 9. The bonding layer that was exposed by removing the release sheet from the release sheet provided with a bonding layer was bonded to the gas barrier layer of the other gas barrier films 18, and the process sheet was removed from each side to obtain a gas barrier film laminate 1 in which two gas barrier films 18 were stacked.

Examples 18 to 23

Gas barrier film laminates 2 to 7 were respectively obtained in the same manner as in Example 17, except that the gas barrier films 19 to 24 obtained in Examples 11 to 16 were respectively used instead of the gas barrier film 18.

Comparative Examples 9 to 12

Gas barrier film laminates 8 to 11 were respectively obtained in the same manner as in Example 17, except that the gas barrier films 10 to 12 and 16 obtained in Comparative Examples 1 to 3 and 7 were respectively used instead of the gas barrier film 18.

Example 24

Two gas barrier film laminates 1 (see Example 17) were provided. The cured resin layer of one of the two gas barrier film laminates 1 was bonded to the bonding layer of the release sheet provided with a bonding layer obtained in Production Example 9.

The bonding layer that was exposed by removing the release sheet from the release sheet provided with a bonding layer was bonded to the cured resin layer of the other gas barrier film laminate 1 to obtain a gas barrier film laminate 12 in which two gas barrier film laminates 1 (i.e., four gas barrier films 18) were bonded (stacked).

Examples 25 and 26

Gas barrier film laminates 13 and 14 were respectively obtained in the same manner as in Example 24, except that the gas barrier film laminates 6 and 7 obtained in Examples 22 and 23 were respectively used instead of the gas barrier film laminate 1.

Measurement of water vapor transmission rate of gas barrier film laminate

The water vapor transmission rate of the gas barrier film laminates 1 to 14 obtained in Examples 17 to 26 and Comparative Examples 9 to 12 was measured in the same manner as described above. The measurement results are shown in Tables 7 and 8.

Evaluation of optical isotropy of gas barrier film laminate

The optical isotropy of the gas barrier film laminates 1 to 14 obtained in Examples 17 to 26 and Comparative Examples 9 to 12 was evaluated based on the birefringence of the cured resin layer or the film.

The optical isotropy of the gas barrier film laminate was evaluated as "Acceptable" when the birefringence of the cured resin layer or the film was less than $20\times10^{-5}$, and evaluated as "Unacceptable" when the birefringence of the cured resin layer or the film was $20\times10^{-5}$ or more. The evaluation results are shown in Tables 7 and 8.

Heat resistance evaluation test using gas barrier film laminate

The gas barrier film laminates 1 to 14 obtained in Examples 17 to 26 and Comparative Examples 9 to 12 were cut to have a width of 4.5 mm to obtain measurement samples.

The measurement sample was secured on a thermomechanical analyzer ("TMA 4000S" manufactured by Mac Science) so that the chuck-to-chuck distance was 15 mm. The atmospheric temperature was increased from 23°C to 150°C at a temperature increase rate of 5°C/min while applying a constant load of -2 gf (i.e., a load of 2 gf in the tensile direction), and the measurement sample was held at 150°C for 30 minutes. The ratio (shrinkage ratio) of the amount of shrinkage with respect to the original length (15 mm) was calculated. The heat resistance was evaluated as "Acceptable" when the shrinkage ratio was less than 0.5%, and evaluated as "Unacceptable" when the shrinkage ratio was more than 0.5%. The evaluation results are shown in Tables 7 and 8.

TABLE 7

| | | Example | | | | | | |
|---|---|---|---|---|---|---|---|---|
| | | 17 | 18 | 19 | 20 | 21 | 22 | 23 |
| Gas barrier film laminate | No. | 1 | 2 | 3 | 4 | 5 | 6 | 7 |
| | Gas barrier film<br>(Cured resin layer or base film)<br>(Gas barrier layer) | 18<br>9<br>PHPS | 19<br>10<br>PHPS | 20<br>11<br>PHPS | 21<br>12<br>PHPS | 22<br>13<br>PHPS | 23<br>13<br>SiN | 24<br>14<br>PHPS |
| | Number of gas barrier films | 2 | 2 | 2 | 2 | 2 | 2 | 2 |
| Water vapor transmission rate ($g/m^2/day$) | | 0.01 | 0.01 | 0.01 | 0.01 | 0.01 | 0.2 | 0.01 |
| Optical isotropy | | Acceptable | Acceptable | Acceptable | Acceptable | Acceptable | Acceptable | Acceptable |
| Heat resistance | | Acceptable | Acceptable | Acceptable | Acceptable | Acceptable | Acceptable | Acceptable |

TABLE 8

| | | Comparative Example | | | | Example | | |
|---|---|---|---|---|---|---|---|---|
| | | 9 | 10 | 11 | 12 | 24 | 25 | 26 |
| Gas barrier film laminate | No. | 8 | 9 | 10 | 11 | 12 | 13 | 14 |
| | Gas barrier film<br>(Cured resin layer or base film)<br>(Gas barrier layer) | 10<br>PET<br>PHPS | 11<br>PET<br>SiN | 12<br>PC<br>PHPS | 16<br>PSF<br>PHPS | 18<br>9<br>PHPS | 23<br>13<br>SiN | 24<br>14<br>PHPS |
| | Number of gas barrier films | 2 | 2 | 2 | 2 | 4 | 4 | 4 |
| Water vapor transmission rate ($g/m^2/day$) | | 0.01 | 0.2 | 0.02 | 0.02 | 0.005 | 0.1 | 0.005 |
| Optical isotropy | | Unacceptable | Unacceptable | Unacceptable | Acceptable | Acceptable | Acceptable | Acceptable |
| Heat resistance | | Unacceptable | Unacceptable | Acceptable | Acceptable | Acceptable | Acceptable | Acceptable |

The results shown in Tables 7 and 8 suggest the following.

The gas barrier film laminates 1 to 7 obtained in Examples 17 to 23 and the gas barrier film laminates 12 to 14 obtained in Examples 24 to 26 exhibited excellent heat resistance, and had a very low water vapor transmission rate.

The gas barrier film laminates 8 and 9 obtained in Comparative Examples 9 and 10 exhibited poor heat resistance. The gas barrier film laminates 11 and 12 obtained in Comparative Examples 11 and 12 (in which the gas barrier films obtained using the film having a high birefringence were bonded) exhibited poor optical isotropy.

REFERENCE SIGNS LIST

1, 1a, 1b, 1c, 1d: cured resin layer
2, 2a, 2b, 2c, 2d, 2’, 2": gas barrier layer
3, 3a, 3b, 3c: bonding layer
4: release sheet
10, 10a, 10b, 10c, 20: gas barrier film
30, 30a, 30b, 40, 40a, 40b, 50, 50a, 50b, 60, 70, 80, 90, 100, 110, 120: gas barrier film laminate
130: release sheet provided with bonding layer
140: gas barrier film provided with bonding layer

## Claims

1. A gas barrier film comprising a cured resin layer (1, 1a, 1b, 1c, 1d) and a gas barrier layer (2, 2a, 2b, 2c, 2d, 2’, 2"), the gas barrier layer being provided on at least one side of the cured resin layer,

   the cured resin layer being a layer composed of a cured product of a curable resin composition that includes (A) a thermoplastic resin having a glass transition temperature (Tg) of 140°C or more, and (B) a curable monomer, wherein the curable resin composition includes the thermoplastic resin (A) and the curable monomer (B) in a mass ratio (thermoplastic resin (A):curable monomer (B)) of 35:65 to 80:20,
   the gas barrier film having a water vapor transmission rate of 1 $g/m^2/day$ or less at a temperature of 40°C and a relative humidity of 90%, wherein at least one of the curable monomer (B) is a polyfunctional (meth)acrylic acid derivative,
   **characterized in that** the thermoplastic resin (A) has a weight average molecular weight (Mw) of 100,000 to 3,000,000.

2. The gas barrier film according to claim 1, wherein the thermoplastic resin (A) is an amorphous thermoplastic resin.

3. The gas barrier film according to claim 1, wherein the thermoplastic resin (A) has an aromatic ring structure or an alicyclic structure.

4. The gas barrier film according to claim 1, wherein the cured resin layer has a gel fraction of 90% or more.

5. The gas barrier film according to claim 1, wherein the gas barrier layer is a layer that is formed by implanting ions into a layer that includes a silicon-containing polymer compound.

6. The gas barrier film according to claim 5, wherein the silicon-containing polymer compound is a polysilazane.

7. The gas barrier film according to claim 1, wherein the gas barrier layer is a layer composed of an inorganic film.

8. The gas barrier film according to claim 1, further comprising a process sheet.

9. A method for producing the gas barrier film according to any one of claims 1 to 8, the method comprising:

   a step 1 that forms a curable resin layer on a process sheet, the curable resin layer being composed of a curable resin composition that includes (A) a thermoplastic resin having a glass transition temperature (Tg) of 140°C or more, and (B) a curable monomer;
   a step 2 that cures the curable resin layer obtained by the step 1 to form a cured resin layer; and

a step 3 that forms a gas barrier layer on the cured resin layer obtained by the step 2.

**10.** A gas barrier film laminate comprising the gas barrier film according to any one of claims 1 to 8, two or more of the gas barrier films being stacked through a bonding layer.

**11.** The gas barrier film laminate according to claim 10, wherein the cured resin layer included in each of the two or more gas barrier films has a thickness of 0.5 to 10 μm.

**12.** An electronic device member comprising the gas barrier film according to any one of claims 1 to 8.

**Patentansprüche**

**1.** Gassperrfolie, umfassend eine gehärtete Harzschicht (1, 1a, 1b, 1c, 1d) und eine Gassperrschicht (2, 2a, 2b, 2c, 2d, 2', 2"), wobei die Gassperrschicht auf mindestens einer Seite der gehärteten Harzschicht aufgebracht ist,

wobei die gehärtete Harzschicht eine Schicht ist, die aus einem gehärteten Produkt einer härtbaren Harzzusammensetzung besteht, die (A) ein thermoplastisches Harz mit einer Glasübergangstemperatur (Tg) von 140°C oder mehr und (B) ein härtbares Monomer enthält, wobei die härtbare Harzzusammensetzung das thermoplastische Harz (A) und das härtbare Monomer (B) in einem Massenverhältnis (thermoplastisches Harz (A):härtbares Monomer (B)) von 35:65 bis 80:20 enthält,
wobei die Gassperrfolie eine Wasserdampfdurchlässigkeit von 1 g/$m^2$/Tag oder weniger bei einer Temperatur von 40°C und einer relativen Luftfeuchtigkeit von 90 % aufweist, wobei mindestens eines der härtbaren Monomere (B) ein polyfunktionelles (Meth)acrylsäurederivat ist, **dadurch gekennzeichnet, dass** das thermoplastische Harz (A) ein gewichtsmittleres Molekulargewicht (Mw) von 100.000 bis 3.000.000 aufweist.

**2.** Gassperrfolie nach Anspruch 1, wobei das thermoplastische Harz (A) ein amorphes thermoplastisches Harz ist.

**3.** Gassperrfolie nach Anspruch 1, wobei das thermoplastische Harz (A) eine aromatische Ringstruktur oder eine alicyclische Struktur aufweist.

**4.** Gasbarrierefolie nach Anspruch 1, wobei die gehärtete Harzschicht einen Gelanteil von 90 % oder mehr aufweist.

**5.** Gassperrschicht nach Anspruch 1, wobei die Gassperrschicht eine Schicht ist, die durch Ionenimplantation in eine Schicht gebildet wird, die eine siliziumhaltige Polymerverbindung enthält.

**6.** Gassperrfolie nach Anspruch 5, wobei die siliziumhaltige Polymerverbindung ein Polysilazan ist.

**7.** Gassperrfolie nach Anspruch 1, wobei die Gassperrschicht eine Schicht ist, die aus einem anorganischen Film besteht.

**8.** Gassperrfolie nach Anspruch 1, die ferner eine Prozessfolie umfasst.

**9.** Verfahren zur Herstellung der Gassperrfolie nach einem der Ansprüche 1 bis 8, wobei das Verfahren umfasst:

einen Schritt 1, der eine härtbare Harzschicht auf einer Prozessfolie bildet, wobei die härtbare Harzschicht aus einer härtbaren Harzzusammensetzung besteht, die (A) ein thermoplastisches Harz mit einer Glasübergangstemperatur (Tg) von 140°C oder mehr und (B) ein härtbares Monomer enthält;
einen Schritt 2, in dem die in Schritt 1 erhaltene härtbare Harzschicht gehärtet wird, um eine gehärtete Harzschicht zu bilden; und
einen Schritt 3, der eine Gassperrschicht auf der in Schritt 2 erhaltenen gehärteten Harzschicht bildet.

**10.** Gassperrfolienlaminat, das die Gassperrfolie nach einem der Ansprüche 1 bis 8 umfasst, wobei zwei oder mehr der Gassperrfolien durch eine Verbindungsschicht gestapelt sind.

**11.** Gassperrfolienlaminat nach Anspruch 10, wobei die gehärtete Harzschicht, die in jeder der zwei oder mehr Gassperrfolien enthalten ist, eine Dicke von 0,5 bis 10 μm aufweist.

**12.** Elektronisches Bauteil, das die Gassperrfolie nach einem der Ansprüche 1 bis 8 umfasst.

## Revendications

**1.** Film barrière aux gaz comprenant une couche de résine durcie (1, 1a, 1b, 1c, 1d) et une couche barrière aux gaz (2, 2a, 2b, 2c, 2d, 2', 2"), la couche barrière aux gaz étant prévue sur au moins un côté de la couche de résine durcie,

la couche de résine durcie étant une couche composée d'un produit durci d'une composition de résine durcissable qui comprend (A) une résine thermoplastique ayant une température de transition vitreuse (Tg) de 140° C ou plus, et (B) un monomère durcissable, dans laquelle la composition de résine durcissable comprend la résine thermoplastique (A) et le monomère durcissable (B) dans un rapport massique (résine thermoplastique (A) :monomère durcissable (B)) de 35:65 à 80:20,
le film barrière aux gaz ayant un taux de transmission de la vapeur d'eau de 1 g/$m^2$/jour ou moins à une température de 40°C et une humidité relative de 90%, dans lequel au moins un des monomères durcissables (B) est un dérivé d'acide (méth)acrylique polyfonctionnel, **caractérisé en ce que** la résine thermoplastique (A) a un poids moléculaire moyen en poids (Mw) de 100 000 à 3 000 000.

**2.** Film barrière aux gaz selon la revendication 1, dans lequel la résine thermoplastique (A) est une résine thermoplastique amorphe.

**3.** Film barrière aux gaz selon la revendication 1, dans lequel la résine thermoplastique (A) a une structure de cycle aromatique ou une structure alicyclique.

**4.** Film barrière aux gaz selon la revendication 1, dans lequel la couche de résine durcie a une fraction de gel de 90% ou plus.

**5.** Film barrière aux gaz selon la revendication 1, dans lequel la couche barrière aux gaz est une couche qui est formée par implantation d'ions dans une couche qui comprend un composé polymère contenant du silicium.

**6.** Film barrière aux gaz selon la revendication 5, dans lequel le composé polymère contenant du silicium est un polysilazane.

**7.** Film barrière aux gaz selon la revendication 1, dans lequel la couche barrière aux gaz est une couche composée d'un film inorganique.

**8.** Film barrière aux gaz selon la revendication 1, comprenant en outre une feuille de traitement.

**9.** Procédé de production du film barrière aux gaz selon l'une quelconque des revendications 1 à 8, le procédé comprenant :

une étape 1 qui forme une couche de résine durcissable sur une feuille de traitement, la couche de résine durcissable étant composée d'une composition de résine durcissable qui comprend (A) une résine thermoplastique ayant une température de transition vitreuse (Tg) de 140° C ou plus, et (B) un monomère durcissable ;
une étape 2 qui durcit la couche de résine durcissable obtenue par l'étape 1 pour former une couche de résine durcie ; et
une étape 3 qui forme une couche de barrière aux gaz sur la couche de résine durcie obtenue par l'étape 2.

**10.** Stratifié de film barrière aux gaz comprenant le film barrière aux gaz selon l'une quelconque des revendications 1 à 8, deux ou plusieurs des films barrière aux gaz étant empilés par l'intermédiaire d'une couche de liaison.

**11.** Stratifié de film barrière aux gaz selon la revendication 10, dans lequel la couche de résine durcie incluse dans chacun des deux ou plus films barrière aux gaz a une épaisseur de 0,5 à 10 μm.

**12.** Élément de dispositif électronique comprenant le film barrière aux gaz selon l'une quelconque des revendications 1 à 8.

FIG. 1

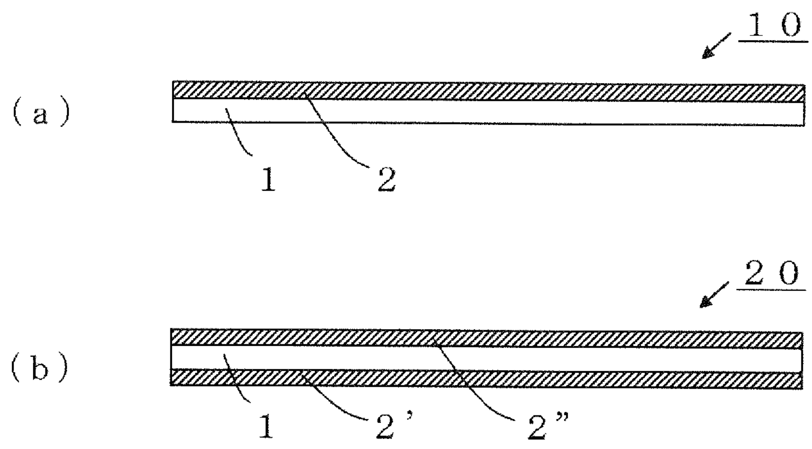
10
(a)
1
2
20
(b)
1
2'
2"

FIG. 2

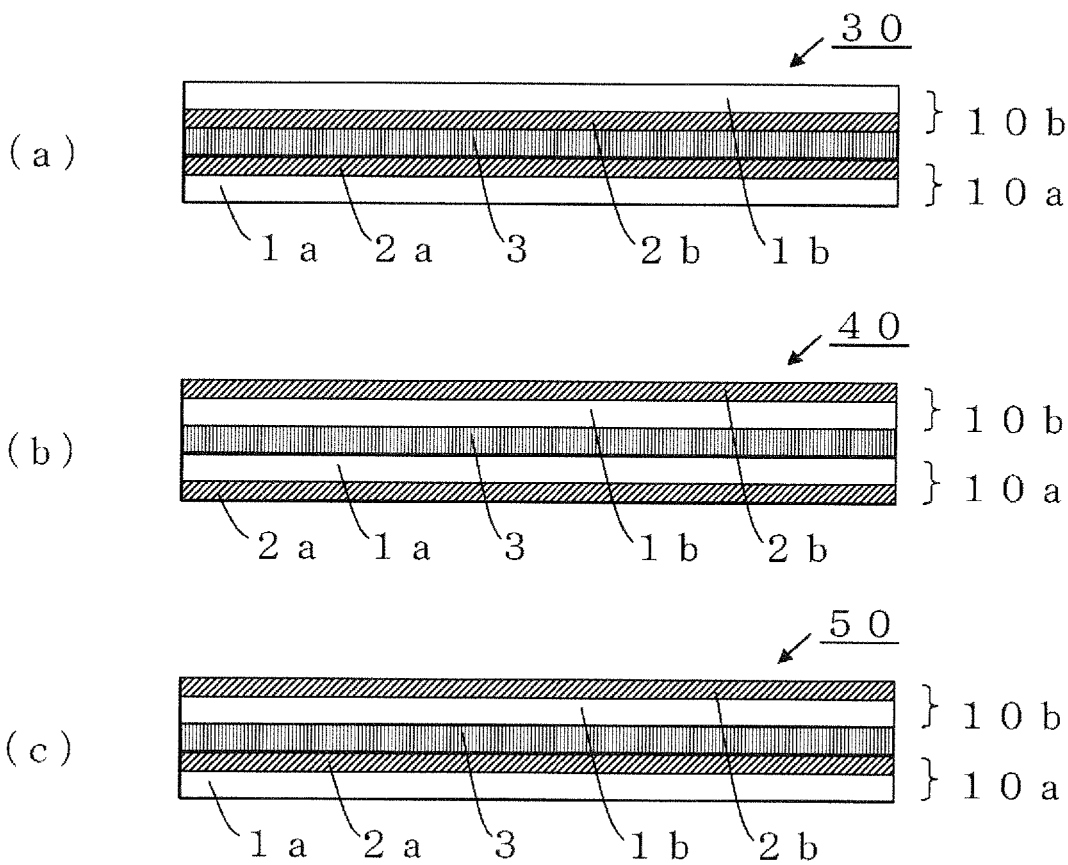
30
(a)
10b
10a
1a
2a
3
2b
1b
40
(b)
10b
10a
2a
1a
3
1b
2b
50
(c)
10b
10a
1a
2a
3
1b
2b

FIG. 3

(a)

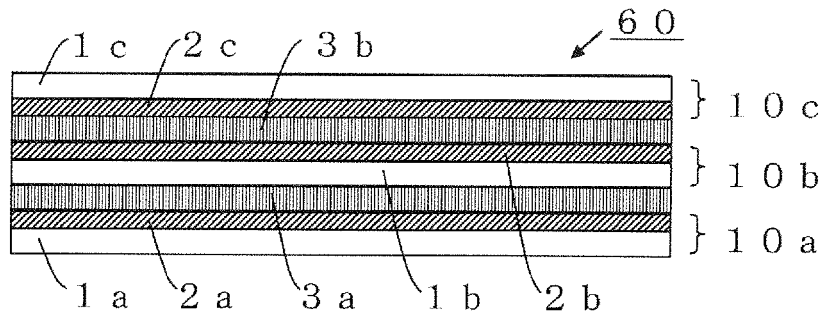


(b)

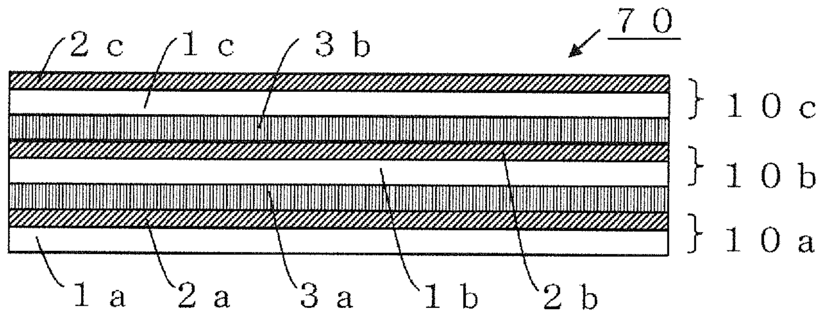


FIG. 4

(a)

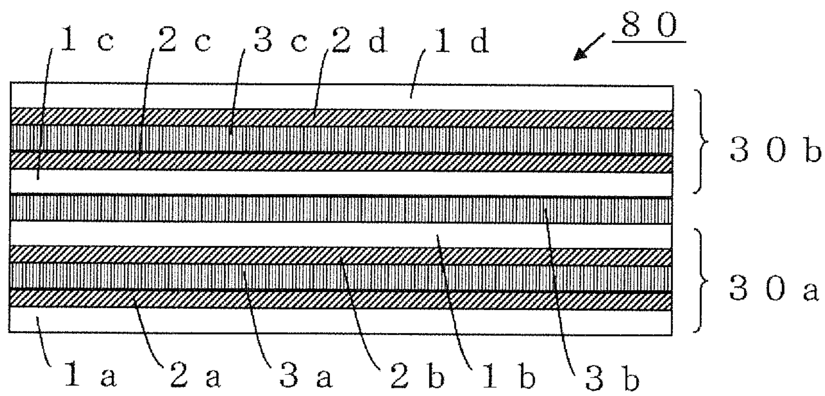


(b)

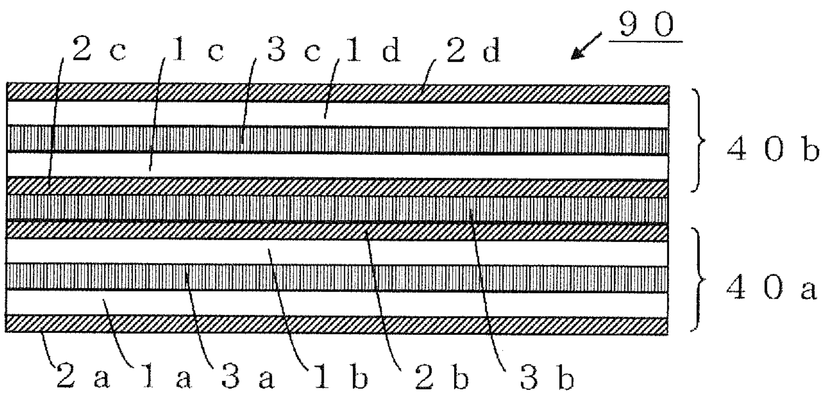

FIG. 5

(a)

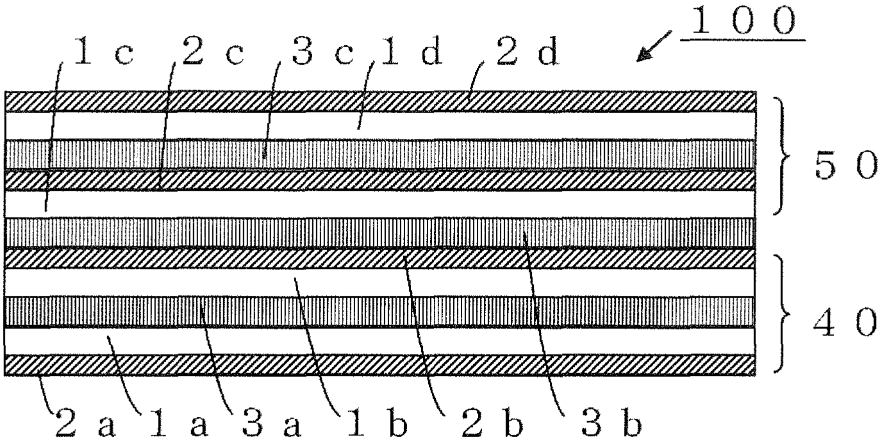
100
1c
2c
3c
1d
2d
50
40
2a
1a
3a
1b
2b
3b

(b)

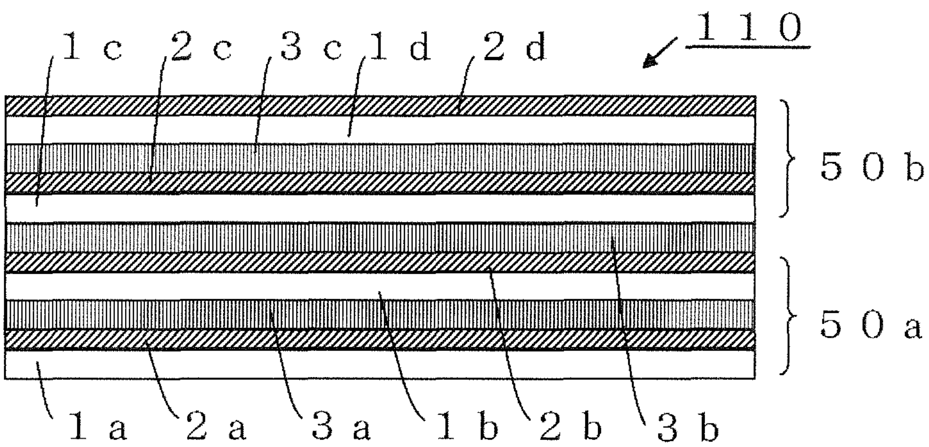
110
1c
2c
3c
1d
2d
50b
50a
1a
2a
3a
1b
2b
3b

(c)

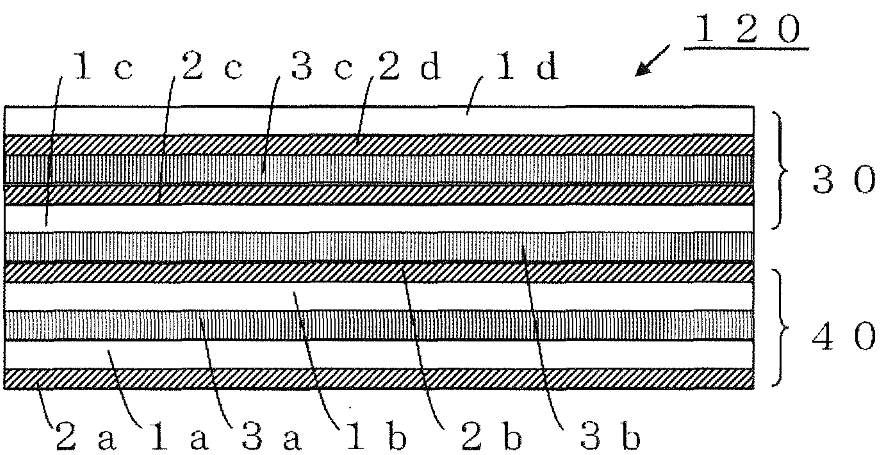
120
1c
2c
3c
2d
1d
30
40
2a
1a
3a
1b
2b
3b

FIG. 6

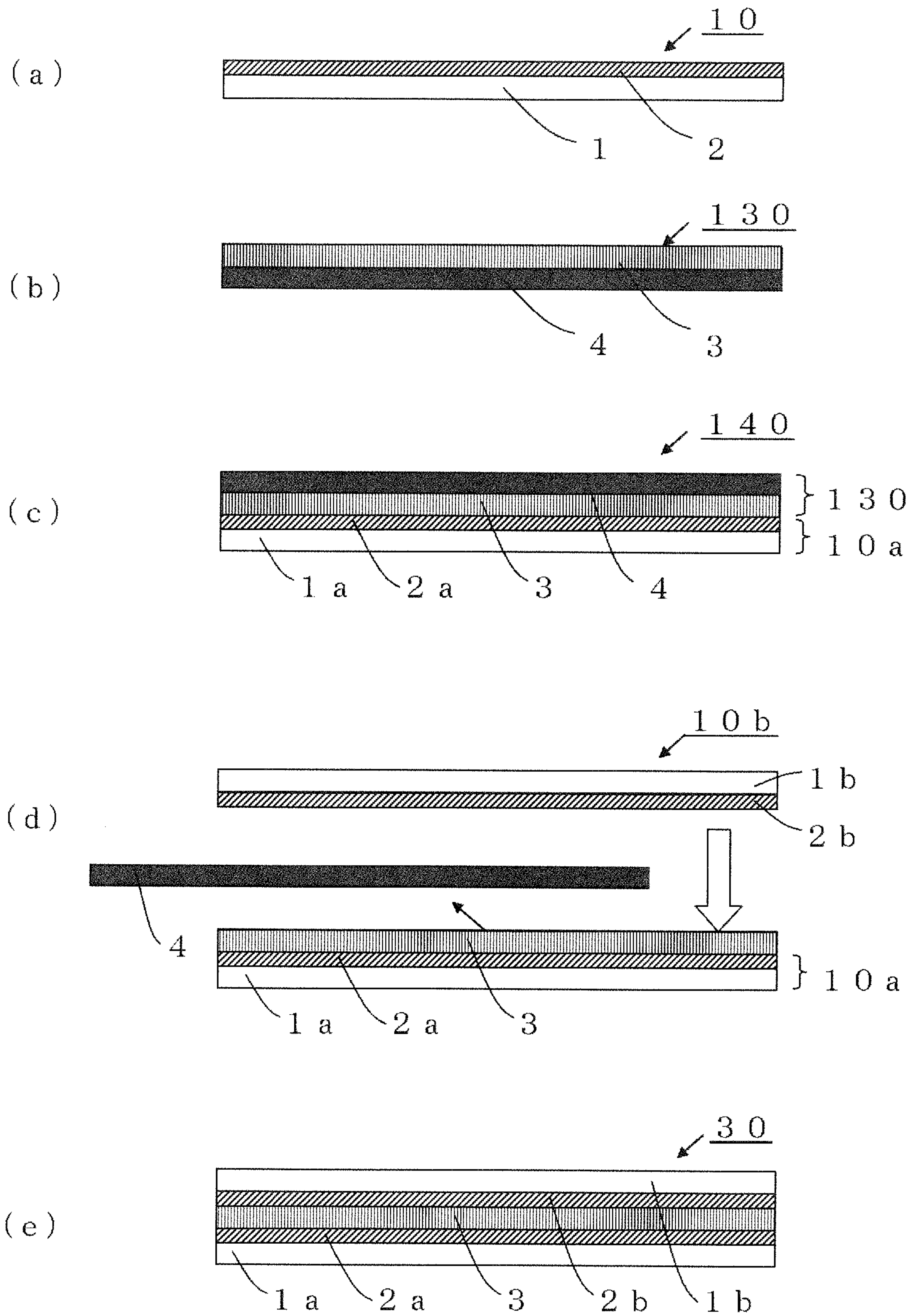
(a)
10
1
2
(b)
130
4
3
(c)
140
130
10a
1a
2a
3
4
(d)
10b
1b
2b
4
10a
1a
2a
3
(e)
30
1a
2a
3
2b
1b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2033988 A
- JP 2000338901 A
- JP 2007237588 A
- JP 63016325 B
- JP 62195024 A
- JP 63081122 A
- JP 1138108 A
- JP 2084437 A
- JP 2175726 A
- JP 4063833 A
- JP 5238827 A
- JP 5345826 A
- JP 2005036089 A
- JP 6122852 A
- JP 6299118 A
- JP 6306329 A
- JP 9031333 A
- JP 10245436 A
- JP 2003514822 T
- WO 2011107018 A
- JP 51126300 A
- JP 2001328991 A
- JP 2006117917 A
- JP 2009286891 A
- JP 2010106100 A
- JP 2008063586 A
- JP 2009235358 A
- JP 2010229445 A
- JP 2010232569 A
- JP 2010238736 A
- JP 2001026887 A
- JP 2001156013 A
- WO 2010021326 A


### Non-patent literature cited in the description


- *Journal of Materials Science,* 1978, vol. 13, 2569-2576
- *Organometallics,* 1991, vol. 10, 1336-1344
- *Journal of Organometallic Chemistry,* 1996, vol. 521, 1-10
- **R.D. MILLER ; J. MICHL.** *Chemical Review,* 1989, vol. 89, 1359
- **N. MATSUMOTO.** *Japanese Journal of Physics,* 1998, vol. 37, 5425